# EUROPEAN PATENT APPLICATION

(11) **EP 2 136 219 A2**
(43) Date of publication of application: **23.12.2009**
(21) Application number: 09251569.1
(22) Date of filing: 16.06.2009
(51) Int. Cl.: G01R 31/36

(54) **Voltage detecting device of assembled battery and assembled battery system comprising same**

(30) Priority: 17.06.2008 JP 2008157578; 12.06.2009 JP 2009140887
(71) Applicant: Sanyo Electric Co., Ltd., Moriguchi-shi Osaka (JP)
(72) Inventor: Kunimitsu, Tomonori, Moriguchi-shi, Osaka (JP)
(74) Representative: Holmes, Matthew Peter

(57) **Abstract**

In the voltage detecting device according to the present invention, voltage detecting lines respectively extend from a plurality of voltage input terminals, a plurality of capacitative elements are respectively interposed on coupling lines each coupling two adjacent voltage detecting lines to each other, and the voltage detecting lines are connected to voltage detecting means. At least all the voltage detecting lines respectively disposed on the positive electrode side of the cells are each connected to ground via one or more disconnection detection resistors. The voltage detecting means detects a disconnection on a wire between each of a plurality of voltage detecting points of the assembled battery and a plurality of voltage input terminals based on voltage inputted from each voltage detecting line.

## Description

### BACKGROUND OF THE INVENTION

### 1. Field of the Invention

The present invention relates to a device detecting a voltage across each of a plurality of cells connected to each other in series to form an assembled battery, and particularly to a voltage detecting device capable of detecting disconnection of a wire between the assembled battery and the device, and an assembled battery system comprising such a device.

### 2. Description of Related Art

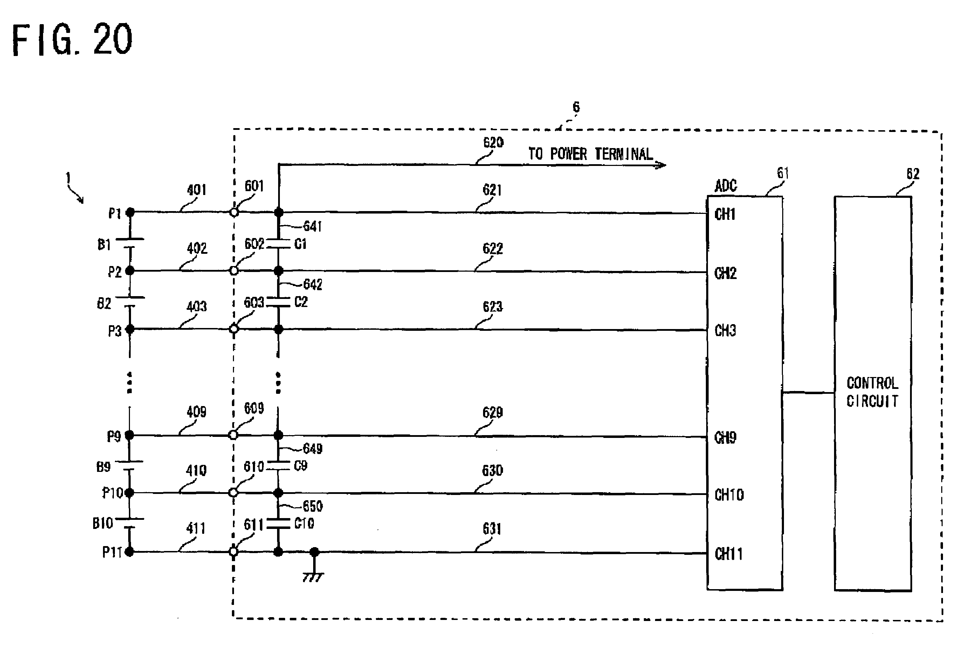

Conventionally, a hybrid vehicle has an assembled battery comprising a plurality of lithium-ion secondary cells connected to each other in series mounted thereon as a power source of a drive motor. However, in such a conventional assembled battery, smoke emission or ignition may occur when the cells forming the assembled battery are overcharged or overdischarged. In view of this, it has been attempted to constitute such a battery system as shown in FIG. 20 to monitor the voltage across each of the cells forming the assembled battery.

This battery system comprises an assembled battery 1 comprising a plurality of cells (10 cells in the example shown in the figure) B1 to B10 connected to each other in series and a voltage detecting device 6 detecting the voltage across each cell. Both ends P1. P11 of the assembled battery 1 and the connecting points P2 to P10 between the cells are connected to 11 voltage input terminals 601 to 611 of the voltage detecting device 6 respectively via wire harnesses 401 to 411. Power supply cables (not shown) extend from the positive and negative electrodes of the assembled battery 1 respectively to be connected to a load such as a drive motor.

In the voltage detecting device 6, voltage detecting lines 621 to 631 extend from the 11 voltage input terminals 601 to 611 respectively, and capacitors C1 to C10 for protecting the circuits from static electricity voltage are interposed on coupling lines 641 to 650 coupling two adjacent voltage detecting lines to each other respectively. A power source line 620 extends from the first voltage detecting line 621 of the 11 voltage detecting lines 621 to 631 to be connected to the power terminal (not shown) of the voltage detecting device 6. The 11th voltage detecting line 631 is connected to ground. The 11 voltage detecting lines 621 to 631 are connected to 11 input terminals of an analogue-digital converter (hereinafter referred to as ADC) 61, and one output terminal of the ADC 61 is connected to a control circuit 62 comprising a micro computer.

In the voltage detecting device 6 described above, the positive electrode potential or negative electrode potential of the cells B1 to B10 forming the assembled battery 1 is generated on the 11 voltage detecting lines 621 to 631 respectively. Then the potentials on the 11 voltage detecting lines 621 to 631 are respectively inputted into the 11 input terminals of the ADC 61. The ADC 61 converts the potential differences between two adjacent input terminals, i.e. the voltage across each cell, into digital voltage detecting data to output the data from the output terminal. The control circuit 62 monitors whether the cells are not overcharged or overdischarged based on the voltage detecting data of the 10 cells obtained from the output terminal of the ADC 61.

In the battery system of the hybrid vehicles, constitutionally, the wire harness connecting the assembled battery and the voltage detecting device to each other is likely to have disconnection. When the disconnection of the wire harness occurs, the voltage across each cell cannot be detected accurately.

Therefore, conventionally, the voltage detecting device with the function of detecting a disconnection of the wire harness between the assembled battery and the device has been provided to detect a disconnection.

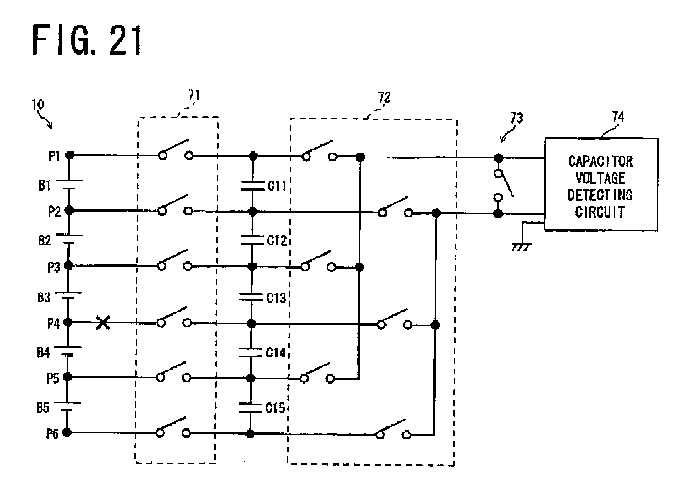

For example, the voltage detecting device shown in FIG. 21 comprises capacitors C11 to C15 connected in parallel to 5 cells B1 to B5 respectively, a first switching circuit 71 provided between the cells B1 to B5 and the capacitors C11 to C15, a capacitor voltage detecting circuit 74 selectively detecting voltages across each of the capacitors C11 to C15, a second switching circuit 72 provided between the capacitors C11 to C15 and the capacitor voltage detecting circuit 74, and a third switching element 73 which short-circuits both ends of each capacitor after detecting the voltage across each capacitor (See Japanese Patent Laid-Open No. 2007-225484). The capacitance of the capacitors C12, C14 is set to m times (m>1) the capacitance of the capacitors C11, C13 and C15.

In the voltage detecting device described above, in the case, for example, where the disconnection occurs on the wire harness extending from the connecting point P4 between the cells B3 and E4 as indicated by a cross mark in the figure, since the capacitance of the capacitor C13 is set to 1/m of the capacitance of the capacitor C14, m times the voltage across the capacitor C14 applies across the capacitor C13. Therefore, the occurrence of a disconnection is determined when the ratio of the voltages across the two adjacent capacitors becomes m or 1/m.

Here, there has been suggested a failure detection device comprising detecting terminals to be respectively connected to both ends of a plurality of cells forming the assembled battery, and detecting a disconnection between the cells and the detecting terminals based on a signal outputted from a failure detection circuit when short-circuiting between the detecting terminals of the odd cells while opening between detecting terminals of the even cells, and a signal outputted from the failure detection circuit when opening between the detecting terminals of the odd cells while short-circuiting between the detecting terminals of the even cells, (See Japanese Patent Laid-Open No. 2005-168118)

Also, there has been suggested a voltage detecting circuit comprising a plurality of voltage input terminals into which the voltage outputted from the secondary cell via a voltage measuring line is inputted, a plurality of voltage sensors connected between the voltage input terminals, and a plurality of constant current sources connected between the voltage input terminals, and capable of detecting the occurrence of a disconnection on the voltage measuring line by means of the voltage sensor (See Japanese Patent Laid-Open No. 2006-27528).

However, in the voltage detecting device shown in FIG. 21, it is problematic because the disconnection is erroneously detected depending on the state of charge of each of the cells forming the assembled battery when no disconnection has occurred.

In other words, when the states of charge of the plurality of cells forming the assembled battery vary and the ratio of the voltages across two adjacent cells becomes m or 1/m, the ratio of the voltages across two capacitors connected in parallel to these cells respectively becomes m or 1/m. Thus, the disconnection is erroneously determined.

### SUMMARY OF THE INVENTION

An object of the present invention is to provide a voltage detecting device capable of preventing the erroneous determination of disconnection when no disconnection has occurred on the wire between the device and the assembled battery, and an assembled battery system comprising such a device.

A first voltage detecting device of the present invention is a device detecting voltage across each of a plurality of cells connected to each other in series to form an assembled battery, wherein the device comprises a plurality of voltage input terminals to be connected to a plurality of voltage detecting points (both ends of the assembled battery and connecting points between the cells) of the assembled battery via wires respectively, voltage detecting lines extend, respectively, from the plurality of voltage input terminals, capacitative elements are respectively interposed on first coupling lines each coupling two adjacent voltage detecting lines to each other, and the voltage detecting lines are connected to voltage detecting means for detecting voltage across each cell based on voltage inputted from each voltage detecting line. At least all the voltage detecting lines respectively disposed on the positive electrode side of the cells (all the voltage detecting lines or the voltage detecting lines other than the one at the end of the assembled battery on the negative electrode side) are each connected to ground via one or more disconnection detection resistors, and the voltage detecting means comprises disconnection detecting means for detecting a disconnection of any of the wires between the plurality of voltage detecting points of the assembled battery and the plurality of voltage input terminals based on voltage inputted from each voltage detecting line,

In the first voltage detecting device of the present invention described above, in the normal state where no disconnection has occurred on any wire, a current is supplied from each cell to each capacitative element interposed between two adjacent voltage detecting lines to maintain each capacitative element in a state where the charge is stored (fully charged state), thereby generating positive or negative electrode potential of each cell on each voltage detecting line. Thus, the voltage detecting means can detect the voltage across each cell based on voltage inputted from each voltage detecting line.

In contrast, in the case where, for example, a disconnection occurs on one wire, the current stops being supplied to the capacitative element connected to the negative electrode side of the voltage detecting line connected to the wire. Then the stored charge is discharged from the capacitative element and flows into ground via the voltage detecting line and the disconnection detection resistor, whereby the potential of the voltage detecting line falls below the potential of the adjacent voltage detecting line on the negative electrode side to become zero or nearly zero. Accordingly, the disconnection detecting means can determine the occurrence of a disconnection when the potential of the voltage detecting line on the positive electrode side falls below the potential of the voltage detecting line on the negative electrode side, or when the potential of the voltage detecting line falls to or below a predetermined threshold value. Here, the threshold value is, for example, set for each voltage detecting line, and is set to the value equal to or below the integration value of the voltages of all the cells interposed between the voltage detecting line at the end of the assembled battery on the negative electrode side and the voltage detecting line for which the threshold value is to be set when the charging capacities of said cells are zero.

In the first voltage detecting device of the present invention described above, in the normal state where no disconnection has occurred, no matter how much the states of charge of the plurality of cells forming the assembled battery vary, the potential of the voltage detecting line on the positive electrode side does not fall below the potential of the voltage detecting line on the negative electrode side, or the potential of the voltage detecting line does not fall below the threshold value to become zero or nearly zero. Therefore, it is not possible that the occurrence of a disconnection is erroneously determined when no disconnection has occurred.

In a particular configuration, a PTC element is interposed on each of at least all the voltage detecting lines respectively disposed on the positive electrode side of the cells (all the voltage detecting lines or the voltage detecting lines other than the one at the end of the assembled battery on the negative electrode side) on the voltage input terminal side of the connecting point to the disconnection detection resistor.

In the particular configuration described above, in the case where an overcurrent flows in the voltage detecting line, the PTC element generates heat, thereby increasing the electric resistance value sharply, As a result, the overcurrent flowing in the voltage detecting line is blocked by the PTC element. Thus, it is possible to prevent the overcurrent from flowing into the subsequent circuit of the PTC element. Even in the state where no disconnection has occurred on any wire, a small amount of current flows into ground via the PTC element and the disconnection detection resistor. However, the resistance value of the PTC element is a few Ω in the normal state, and thus, the voltage drop amount is a negligible amount. Therefore, it is possible to detect the voltage across each cell with the accuracy as high as a voltage detecting device without a PTC element.

A first voltage detecting circuit according to the present invention is connected to a circuit comprising a plurality of voltage input terminals to be respectively connected to a plurality of voltage detecting points of an assembled battery, a plurality of voltage detecting lines respectively extending from the plurality of voltage input terminals, and capacitative elements respectively interposed on coupling lines each coupling two adjacent voltage detecting lines to each other, thereby constituting the first voltage detecting device according to the present invention described above.

A second voltage detecting device according to the present invention is a device detecting voltage across each of a plurality of cells connected to each other in series to form an assembled battery, wherein the device comprises a plurality of voltage input terminals to be connected to a plurality of voltage detecting points (both ends of the assembled battery and connecting points between the cells) of the assembled battery via wires respectively, voltage detecting lines extend, respectively, from the plurality of voltage input terminals, capacitative elements are respectively interposed on first coupling lines each coupling two adjacent voltage detecting lines to each other, and the voltage detecting lines are connected to voltage detecting means for detecting voltage across each cell based on voltage inputted from each voltage detecting line. At least all the voltage detecting lines respectively disposed on the positive electrode side of the cells (all the voltage detecting lines or the voltage detecting lines other than the one at the end of the assembled battery on the negative electrode side) are each connected to ground via one or more disconnection detection resistors, rectifying devices are respectively interposed on second coupling lines each coupling two adjacent voltage detecting lines to each other with a forward direction of the rectifying devices facing the positive electrode side of the assembled battery, and the voltage detecting means comprises disconnection detecting means for detecting a disconnection of any of the wires between the plurality of voltage detecting points of the assembled battery and the plurality of voltage input terminals based on voltage inputted from each voltage detecting line.

In the second voltage detecting device of the present invention described above, in the normal state where no disconnection has occurred on any wire, a current is supplied from each cell to each capacitative element interposed between two adjacent voltage detecting lines to maintain each capacitative element in the state where the charge is stored (fully charged state), thereby generating the positive or negative electrode potential of each cell on each voltage detecting line. Thus; the voltage detecting means can detect voltage across each cell based on voltage inputted from each voltage detecting line.

In contrast, in the case of occurrence of a disconnection on one wire, the current stops being supplied to the capacitative element connected to the negative electrode side of the voltage detecting line connected to the wire. Then the stored charge is discharged from the capacitative element and flows into ground via the voltage detecting line and the disconnection detection resistor, whereby the potential of the voltage detecting line decreases. When the potential of the voltage detecting line becomes equal to the potential of the adjacent voltage detecting line on the negative electrode side in this process, the current starts flowing from the voltage detecting line on the negative electrode side via the rectifying device into the voltage detecting line connected to the wire on which the disconnection occurred. Therefore, the potential of the voltage detecting line does not fall below the potential of the adjacent voltage detecting line on the negative electrode side, whereby the potential difference of both voltage detecting lines becomes zero or nearly zero. Thus, the disconnection detecting means can determine the occurrence of a disconnection when the potential difference of two adjacent voltage detecting lines falls to or below a predetermined threshold value. Here, the threshold value is set for two adjacent voltage detecting lines, i.e. for each cell, and is set to the value equal to or below voltage across each cell at the time the charging capacity of the cell is zero.

In the second voltage detecting device according to the present invention described above, in the normal state where no disconnection has occurred, no matter how much the states of charge of the plurality of cells forming the assembled battery vary, the potential difference of two adjacent voltage detecting lines does not fall below the predetermined threshold value to become zero or nearly zero. Therefore, it is not possible that the occurrence of a disconnection is erroneously determined in the state where no disconnection has occurred.

In a configuration in which no rectifying device is provided, in the case where a disconnection occurs on one wire, the potential of the voltage detecting line connected to the disconnected wire falls below the potential of the adjacent voltage detecting line on the negative electrode side. Then a voltage of opposite electrode is applied between the two input terminals of the voltage detecting means, to which both the voltage detecting lines are respectively connected, while a high voltage is applied between the two input terminals of the voltage detecting means, to which the voltage detecting line connected to the disconnected wire and the adjacent voltage detecting line on the positive electrode side are respectively connected.

On the other hand, in the second voltage detecting device according to the present invention described above, since the rectifying device is interposed between two adjacent voltage detecting lines with its forward direction facing the positive electrode side of the assembled battery, the potential of the voltage detecting line connected to the disconnected wire does not fall below the potential of the adjacent voltage detecting line on the negative electrode side as described above. Therefore, it is possible to prevent a voltage of opposite electrode and a high voltage from being applied to the voltage detecting means.

In a particular configuration, a plurality of current lines extend, respectively, from the at least all the voltage detecting lines respectively disposed on the positive electrode side of the cells, one of the plurality of current lines is connected to ground via a disconnection detection ON/OFF switching element while the other current lines are connected to said one current line, and the one or more disconnection detection resistors are interposed on each current line.

In the state where the disconnection detection ON/OFF switching element is ON, a small amount of current flows from each of the cells forming the assembled battery into ground via the voltage detecting line and the disconnection detection resistor. Therefore, for example, if the switching element is set to ON in the state where the power of the voltage detecting device is OFF and thus it is not possible to detect the disconnection, the electric power of the cells is consumed wastefully.

In the particular configuration described above, for example, the disconnection detection ON/OFF switching element is set to ON only in the state where the power of the voltage detecting device is ON, thereby preventing the electric power of the cells from being consumed wastefully.

Also, in a particular configuration, a rectifying device is interposed on each current line with its forward direction facing the ground side. Thus, it is possible to prevent the current from flowing reversely from the current line having higher voltage to the current line having lower voltage.

In a further particular configuration, the number of disconnection detection resistors for each voltage detecting line is one, and the resistance value of the disconnection detection resistor is set to greater value as the disconnection detection resistor is connected to the voltage detecting line closer to the positive electrode of the assembled battery.

A small amount of current flows from each of the cells forming the assembled battery into ground via the voltage detecting line and the disconnection detection resistor. Here, the current flows from the first cell disposed at the end of the assembled battery on the positive electrode side into only the first disconnection detection resistor, from the second cell into the first and second disconnection detection resistors, from the third cell into the first, second and third disconnection detection resistors, and from the n-th cell into the first to n-th disconnection detection resistors. Therefore, the consumption currents of the cells vary, whereby the voltages across the cells vary. In view of this, the resistance value of the disconnection detection resistor is set to greater value as the disconnection detection resistor is connected to the voltage detecting line closer to the positive electrode of the assembled battery, thereby maintaining the variety of the consumption currents of the cells small.

Alternatively, the number of disconnection detection resistors for each voltage detecting line is more than one, and the resistance values of the disconnection detection resistors are set so that the sum of the resistance values (combined resistance value) of the more than one disconnection detection resistors is greater as they are connected to the voltage detecting line closer to the positive electrode of the assembled battery.

In a still further particular configuration, a PTC element is interposed, on the voltage input terminal side of the connecting point to the disconnection detection resistor, on each of at least all the voltage detecting lines respectively disposed on the positive electrode side of the cells (all the voltage detecting lines or the voltage detecting lines other than the one at the end of the assembled battery on the negative electrode side).

In the particular configuration described above, when an overcurrent flows in the voltage detecting line, the PTC element generates heat, thereby increasing the electric resistance value sharply. As a result, the overcurrent flowing in the voltage detecting line is blocked by the PTC element. Thus, it is possible to prevent the overcurrent from flowing into the subsequent circuit of the PTC element. Even in the state where no disconnection has occurred on any wire, a small amount of current flows into ground via the PTC element and the disconnection detection resistor. However, the resistance value of the PTC element is a few Ω in the normal state, and thus, the voltage drop amount is a negligible amount. Therefore, it is possible to detect voltage across each cell with the accuracy as high as a voltage detecting device without a PTC element.

A second voltage detecting circuit according to the present invention is connected to a circuit comprising a plurality of voltage input terminals to be respectively connected to a plurality of voltage detecting points of an assembled battery, a plurality of voltage detecting lines respectively extending from the plurality of voltage input terminals, and capacitative elements interposed on coupling lines each coupling two adjacent voltage detecting lines to each other, thereby constituting the second voltage detecting device according to the present invention described above.

A voltage detecting device having a function of equalizing the states of charge of the cells forming an assembled battery is conventionally known.

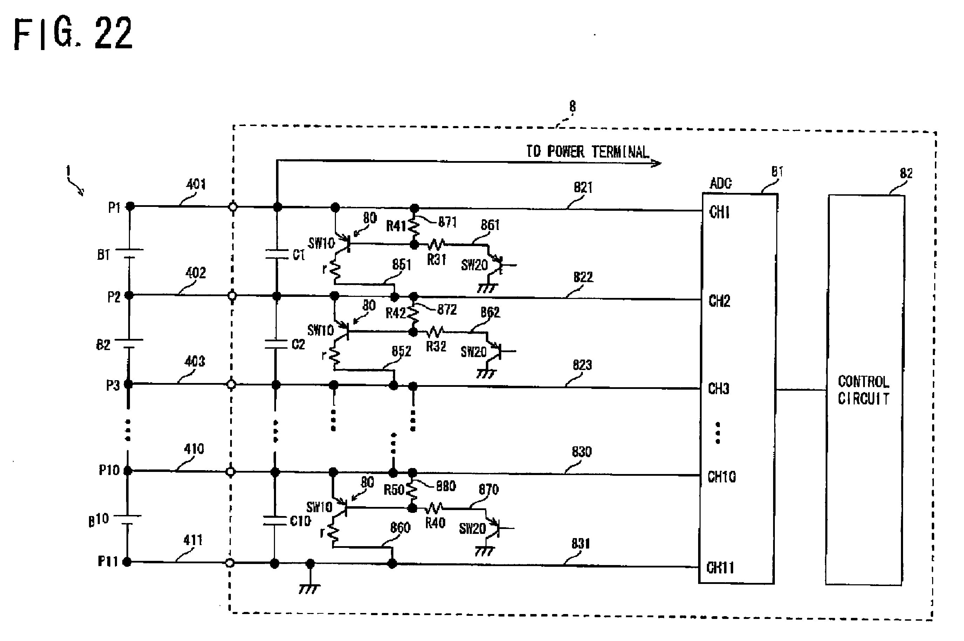

For example, in a conventional voltage detecting device 8 shown in FIG. 22, discharging circuits 80 each comprising an equalizing resistor r and a first discharge ON/OFF switching element SW10 comprising a transistor connected to each other in series are respectively interposed on coupling lines 851 to 860 each coupling two adjacent voltage detecting lines to each other. Current lines 861 to 870 each extends from the base of a first discharge ON/OFF switching element SW10, and each of the current lines is connected to ground via a second discharge ON/OFF switching element SW20. Each second discharge ON/OFF switching element SW20 is controlled ON/OFF by a control circuit 82.

First switching control resistors R31 to R40 are respectively interposed on the current lines 861 to 870, while second switching control resistors R41 to R50 are respectively interposed on coupling lines 871 to 880 each coupling an end of each of the resistors R31 to R40 on the discharging circuits 80 side and each of the voltage detecting lines 821 to 830 on the positive electrode side of the discharging circuits 80 to each other. When the second discharge ON/OFF switching element SW20 is set to ON by the control circuit 82, the first discharge ON/OFF switching element SW10 is also set to ON to discharge the cells.

In the conventional voltage detecting device 8 described above, in the event of a stuck-ON fault which causes the first discharge ON/OFF switching element SW10 to be permanently ON, the cell connected to the discharging circuit having the stuck-ON fault is permanently discharged by said discharging circuit, thereby reducing the capacity of the cell.

As a result of an extensive study, the inventors of the present invention have arrived at providing at least two switching elements in the discharging circuit, and using the two switching control resistors each connected to the one or more switching elements of the two switching elements as the disconnection detection resistors as well. Then they completed the third and fourth voltage detecting devices according to the present invention.

A third voltage detecting device according to the present invention is a device detecting voltage across each of the cells connected to each other in series to form an assembled battery, wherein the device comprises a plurality of voltage input terminals to be connected to a plurality of voltage detecting points (both ends of the assembled battery and connecting points between the cells) of the assembled battery via wires respectively, voltage detecting lines extend, respectively, from the plurality of voltage input terminals, capacitative elements are respectively interposed on first coupling lines each coupling two adjacent voltage detecting lines to each other, and the voltage detecting lines are connected to voltage detecting means for detecting voltage across each cell based on voltage inputted from each voltage detecting line. Discharging circuits each comprising at least two switching elements and one or more resistors connected to each other in series are respectively interposed on second coupling lines each coupling two adjacent voltage detecting lines to each other. A base or gate of at least one switching element of the at least two switching elements of each discharging circuit is connected to ground via a first resistance circuit comprising one or more resistors, second resistance circuits each comprising one or more resistors are respectively interposed on third coupling lines each coupling an end of the first resistance circuit on the discharging circuit side and the voltage detecting line located on the positive electrode side of each of the discharging circuits to each other. The voltage detecting means comprises disconnection detecting means for detecting a disconnection of any of the wires between the plurality of voltage detecting points of the assembled battery and the plurality of voltage input terminals based on voltage inputted from each voltage detecting line.

In the third voltage detecting device according to the present invention described above, a current is supplied from each cell to each capacitative element interposed between two adjacent voltage detecting lines to maintain each capacitative element in a state where the charge is stored (fully charged state), while a small amount of current flows into ground via the voltage detecting line, the second resistance circuit and the first resistance circuit for switching control/disconnection detection.

In the normal state where no disconnection has occurred on any wire, the capacitative elements are maintained in the fully charged state, thereby generating the positive or negative electrode potential of each cell on each voltage detecting line. Therefore, the voltage detecting means can detect voltage across each cell based on voltage inputted from each voltage detecting line.

Further, the voltage detecting device described above has a function of equalizing the states of charge of the cells forming the assembled battery. In the equalizing process, for example, the discharging circuit discharges the cell having the voltage thereacross exceeding an equalizing target voltage. In the state where a small amount of current flows from each cell into ground as described above, When, for example, the switching element other than said one or more switching elements comprising a transistor or an FET (Field Effect Transistor) of the at least two switching elements connected to the cell to be discharged is set to ON, said one or more switching elements are also turned ON. And then, the current starts flowing from the cell to the at least two switching elements and the one or more resistors of the discharging circuit, thereby discharging the cell. Thus the states of charge of the cells can be equalized.

Also, in the case where, for example, a disconnection occurs on one wire, the current stops being supplied to the capacitative element connected to the negative electrode side of the voltage detecting line connected to the wire. Then the stored charge is discharged from the capacitative element and flows into ground via the voltage detecting line, the second resistance circuit and the first resistance circuit, whereby the potential of the voltage detecting line falls below the potential of the adjacent voltage detecting line on the negative electrode side to become zero or nearly zero. Accordingly, the disconnection detecting means can determine the occurrence of a disconnection when the potential of the voltage detecting line on the positive electrode side falls below the potential of the voltage detecting line on the negative electrode side, or when the potential of the voltage detecting line falls to or below a predetermined threshold value. Here, the threshold value is, for example, set for each voltage detecting line, and is set to the value equal to or below the integration value of the voltages of all the cells disposed between the voltage detecting line at the end of the assembled battery on the negative electrode side and the voltage detecting line for which the threshold value is to be set when the charging capacities of said cells are zero.

In the third voltage detecting device of the present invention described above, in the normal state where no disconnection has occurred, no matter how much the states of charge of the plurality of cells forming the assembled battery vary, the potential of the voltage detecting line on the positive electrode side does not fall below the potential of the voltage detecting line on the negative electrode side, and the potential of the voltages detecting line does not fall below the threshold value to become zero or nearly zero. Therefore, it is not possible that the occurrence of a disconnection is erroneously determined when no disconnection has occurred.

In a particular configuration, a PTC element interposed, on the voltage input terminal side of the second coupling line, on each of at least all the voltage detecting lines respectively disposed on the positive electrode side of the cells (all the voltage detecting lines or the voltage detecting lines other than the one at the end of the assembled battery on the negative electrode side).

In the particular configuration described above, when an overcurrent flows in the voltage detecting line, the PTC element generates heat, thereby increasing the electric resistance value sharply. As a result, the overcurrent flowing in the voltage detecting line is blocked by the PTC element. Thus, it is possible to prevent an overcurrent from flowing into the subsequent circuit of the PTC element. Even in the state where no disconnection has occurred on any wire, a small amount of current flows into ground via the PTC element, the second resistance circuit and the first resistance circuit. However, the resistance value of the PTC element is a few Ω in the normal state, and thus, the voltage drop amount is a negligible amount. Therefore, it is possible to detect voltage across each cell with the accuracy as high as a voltage detecting device without a PTC element.

A third voltage detecting circuit according to the present invention is connected to a circuit comprising a plurality of voltage input terminals to be connected to a plurality of voltage detecting points of an assembled battery, a plurality of voltage detecting lines respectively extending from the plurality of voltage input terminals, and capacitative elements interposed on coupling lines each coupling two adjacent voltage detecting lines to each other, thereby constituting the third voltage detecting device according to the present invention described above.

A fourth voltage detecting device according to the present invention is a device detecting voltage across each of the cells connected to each other in series to form an assembled battery, wherein the device comprises a plurality of voltage input terminals to be connected to a plurality of voltage detecting points (both ends of the assembled battery and connecting points between the cells) of the assembled battery via wires respectively, voltage detecting lines extend, respectively, from the plurality of voltage input terminals, capacitative elements are respectively interposed on first coupling lines each coupling two adjacent voltage detecting lines to each other, the voltage detecting lines are connected to voltage detecting means for detecting voltage across each cell based on voltage inputted from each voltage detecting line. Discharging circuits each comprising at least two switching elements and one or more resistors connected to each other in series are respectively interposed on second coupling lines each coupling two adjacent voltage detecting lines to each other. A base or gate of at least one switching element of the at least two switching elements of each discharging circuit is connected to ground via a first resistance circuit comprising one or more resistors, second resistance circuits each comprising one or more resistors are respectively interposed on third coupling lines each coupling an end of the first resistance circuit on the discharging circuit side and the voltage detecting line located on the positive electrode side of each of the discharging circuits to each other, and rectifying devices are interposed on fourth coupling lines each coupling two adjacent voltage detecting lines to each other with a forward direction of the rectifying devices facing the positive electrode side of the assembled battery. The voltage detecting means comprises disconnection detecting means for detecting a disconnection of any of the wires between the plurality of voltage detecting points of the assembled battery and the plurality of voltage input terminals based on voltage inputted from each voltage detecting line.

In the fourth voltage detecting device of the present invention described above, a current is supplied from each cell to each capacitative element interposed between two adjacent voltage detecting lines to maintain each capacitative element in a state where the charge is stored (fully charged state), while a small amount of current flows into ground via the voltage detecting line, the second resistance circuit and the first resistance circuit for switching control/disconnection detection.

In the normal state where no disconnection has occurred on any wire, the capacitative elements are maintained in the fully charged state as described above, thereby generating the positive or negative electrode potential of each cell on each voltage detecting line. Therefore, the voltage detecting means can detect voltage across each cell based on voltage inputted from each voltage detecting line.

Further, the voltage detecting device described above has a function of equalizing the states of charge of the cells forming the assembled battery. In the equalizing process, for example, the cell having a voltage thereacross exceeding an equalization target voltage is discharged by the discharging circuit. In the state where a small amount of current flows from each cell into ground as described above, when, for example, the switching element other than one or more switching elements comprising a transistor or an FET of the at least two switching elements connected to the cell to be discharged is set to ON, said one or more switching elements also are turned ON. Then the current starts flowing from the cell to the at least two switching elements and the one or more resistors of the discharging circuit, thereby discharging the cell. Thus the states of charge of the cells can be equalized.

Also, in the case where, for example, a disconnection occurs on one wire, the current stops being supplied to the capacitative element connected to the negative electrode side of the voltage detecting line connected to the wire. Then the stored charge is discharged from the capacitative element and flows into ground via the voltage detecting line, the second resistance circuit and the first resistance circuit, whereby the potential of the voltage detecting line decreases. When the potential of the voltage detecting line becomes equal to the potential of the adjacent voltage detecting line on the negative electrode side in this process, the current starts flowing from the voltage detecting line on the negative electrode side via the rectifying device into the voltage detecting line connected to the wire on which the disconnection occurred. Therefore, the potential of the voltage detecting line does not fall below the potential of the voltage detecting line on the negative electrode side, whereby the potential difference of both voltage detecting lines becomes zero or nearly zero. Thus, the disconnection detecting means can determine the occurrence of a disconnection when the potential difference of two adjacent voltage detecting lines falls to or below a predetermined threshold value. Here, the threshold value is set for two adjacent voltage detecting lines, i.e. for each cell, and is set to the value equal to or below the voltage across each cell at the time the charging capacity of the cell is zero.

In the fourth voltage detecting device according to the present invention described above, in the normal state where no disconnection has occurred, no matter how much the states of charge of the plurality of cells forming the assembled battery vary, the potential difference of two adjacent voltage detecting lines does not fall below the predetermined threshold value to become zero or nearly zero. Therefore, it is not possible that the occurrence of a disconnection is erroneously determined when no disconnection has occurred.

In a configuration without a rectifying device, in the case where a disconnection occurs on one wire, the potential of the voltage detecting line connected to the disconnected wire falls below the potential of the adjacent voltage detecting line on the negative electrode side. Then a voltage of opposite electrode is applied between the two input terminals of the voltage detecting means, to which both the voltage detecting lines are respectively connected, while a high voltage is applied between the two input terminals of the voltage detecting means, to which the voltage detecting line connected to the disconnected wire and the adjacent voltage detecting line on the positive electrode side are respectively connected.

On the other hand, in the fourth voltage detecting device according to the present invention, since the rectifying device is interposed between two adjacent voltage detecting lines with its forward direction facing the positive electrode side of the assembled battery, the potential of the voltage detecting line connected to the disconnected wire does not fall below the potential of the adjacent voltage detecting line on the negative electrode side as described above. Therefore, it is possible to prevent a voltage of opposite electrode and a high voltage from being applied on the voltage detecting means.

In a particular configuration, a current line extends from the base or gate of one switching element of each discharging circuit, One of the plurality of current lines is connected to ground via a disconnection detection ON/OFF switching element while other current lines are connected to said one current line. The first resistance circuit is interposed on each current line.

In the state where the disconnection detection ON/OFF switching element is ON, a small amount of current flows from each of the cells forming the assembled battery into ground via the voltage detecting line, the second resistance circuit and the first resistance circuit. Therefore, if, for example, the switching element is set to ON in the state where the power of the voltage detecting device is OFF and thus it is not possible to detect a disconnection, the electric power of the cells is consumed wastefully.

In the particular configuration described above, for example, the disconnection detection ON/OFF switching element is set to ON only in the state where the power of the voltage detecting device is ON, thereby preventing the electric power of the cells from being consumed wastefully.

Further, in the particular configuration described above, even when the stuck-ON fault occurs on the switching element other than the one switching element comprising a transistor or an FET of the at least two switching elements constituting the discharging circuit, said one switching element does not turn ON as long as the disconnection detection ON/OFF switch is set OFF. Therefore, the cell connected to the discharging circuit having the stuck-ON fault is not discharged by the discharging circuit.

In a particular configuration, rectifying devices are respectively interposed on current lines with a forward direction of the rectifying devices facing the ground side. It is thus possible to prevent the current from flowing reversely from the current line having higher voltage to the current line having lower voltage.

In a further particular configuration, each discharging circuit has the rectifying device with its forward direction facing the negative electrode side of the assembled battery. Thus, in the event of disconnection of a wire, it is possible to prevent the current from flowing reversely from the voltage detecting line having lower voltage of two adjacent voltage detecting lines to the discharging circuit interposed between the two voltage detecting lines.

In a still further particular configuration, the resistance values of the first and second resistance circuits are set so that the sum of the resistance values of both circuits is greater as they are connected to the voltage detecting line closer to the positive electrode of the assembled battery.

A small amount of current flows from each of the cells forming the assembled battery into ground via the voltage detecting line, the second resistance circuit and the first resistance circuit. Here, the current flows from the first cell disposed at the end of the assembled battery on the positive electrode side into only the first two resistance circuits (the first and second resistance circuits), from the second cell into the first two resistance circuits and second two resistance circuits, from the third cell into the first two resistance circuits, second two resistance circuits and third two resistance circuits, and from the n-th cell into the first to n-th two resistance circuits. Therefore, the consumption currents of the cells vary, whereby the voltages across the cells vary. In the view of this, the resistance values of the first and second resistance circuits are set so that the sum of the resistance values of both circuits is greater as they are connected to the voltage detecting line closer to the positive electrode of the assembled battery. Thus the consumption currents of the cells vary within a narrow range.

In another particular configuration, a PTC element interposed, on the voltage input terminal side of the second coupling line, on each of at least all the voltage detecting lines respectively disposed on the positive electrode side of the cells (all the voltage detecting lines or the voltage detecting lines other than the one at the end of the assembled battery on the negative electrode side).

In the particular configuration described above, when an overcurrent flows in the voltage detecting line, the PTC element generates heat, thereby increasing the electric resistance value sharply. As a result, the overcurrent flowing in the voltage detecting line is blocked by the PTC element. It is thus possible to prevent the overcurrent from flowing into the subsequent circuit of the PTC element. Even in the state where no disconnection has occurred on any wire, a small amount of current flows into ground via the PTC element and the first and second resistance circuits. However, the resistance value of the PTC element is a few Ω in the normal state, and thus, the voltage drop amount is a negligible amount. Therefore, it is possible to detect voltage across each cell with the accuracy as high as a voltage detecting device without a PTC element.

A fourth voltage detecting circuit according to the present invention is connected to a circuit comprising a plurality of voltage input terminals to be connected to a plurality of voltage detecting points of an assembled battery, a plurality of voltage detecting lines respectively extending from the plurality of voltage input terminals, and capacitative elements respectively interposed on coupling lines each coupling two adjacent voltage detecting lines to each other, thereby constituting the fourth voltage detecting device according to the present invention described above.

The assembled battery system according to the present invention comprises an assembled battery comprising a plurality of cells connected to each other in series and a voltage detecting device detecting voltage across each of the cells forming the assemble battery, and adopts, as said voltage detecting device, any one of the first to fourth voltage detecting device according to the present invention described above.

An electric vehicle according to the present invention operates using as a power source an assembled battery comprising a plurality of cells connected to each other in series, and a voltage detecting device is connected to the assembled battery detecting voltage across each of the cells forming the assembled battery. The electric vehicle adopts as said voltage detecting device any one of the first to fourth voltage detecting device according to the present invention described above.

As described above, according to the voltage detecting device and the assembled battery system of the present invention, it is possible to prevent the occurrence of a disconnection from being erroneously determined in the state where no disconnection has occurred on any wire between the assembled battery and the device.

### BRIEF DESCRIPTION OF THE DRAWINGS

FIG. 1 is a circuit diagram showing the structure of a battery system according to the first embodiment of the present invention;
FIG. 2 is a circuit diagram showing the current flow path at the time of occurrence of a disconnection on a wire harness in the battery system;
FIG. 3 is a graph showing the change of the voltages across two capacitors C2, C3 at the time of occurrence of a disconnection on a third wire harness in the battery system;
FIG. 4 is a circuit diagram showing the current flow path at the time of occurrence of a disconnection on a 11th wire harness in the battery system;
FIG. 5 is a circuit diagram showing the structure of a battery system according to the second embodiment of the present invention;
FIG. 6 is a circuit diagram showing the structure of a battery system according to the third embodiment of the present invention;
FIG. 7 is a circuit diagram to explain a function of a diode of a discharging circuit constituting the battery system;
FIG 8 is a circuit diagram showing the current flow path when a disconnection detection ON/OFF switching element SW is set to ON in the battery system;
FIG. 9 is a circuit diagram showing the current flow path in an equalizing process in the battery system;
FIG. 10 is a circuit diagram showing the current flow path at the time of occurrence of a disconnection on a wire harness in the battery system;
FIG. 11 is a circuit diagram showing the structure of a battery system according to the fourth embodiment of the present invention;
FIG. 12 is a circuit diagram to explain a problem that arises when a protective resistor is disposed on the assembled battery side of a current line having a disconnection detection resistor interposed thereon;
FIG. 13 is a circuit diagram showing the combined resistance in the case of generation of dew condensation in the resistor having a resistance value of 1MΩ;
FIG. 14 is a circuit diagram showing the combined resistance in the case of generation of dew condensation in the resistor having a resistance value of 100kΩ;
FIG. 15 is a circuit diagram showing the structure of a battery system according to the fifth embodiment of the present invention;
FIG. 16 is a circuit diagram showing a modification of the battery system according to the third embodiment of the present invention;
FIG. 17 is a circuit diagram showing a modification of the battery system shown in FIG. 15;
FIG. 18 is a circuit diagram showing a modification of the battery system shown in FIG. 16;
FIG. 19 is a block diagram showing the structure of an electric vehicle according to the present invention;
FIG. 20 is a circuit diagram showing the structure of a conventional battery system;
FIG. 21 is a circuit diagram showing the structure of a conventional voltage detecting device having a disconnection detecting function; and
FIG. 22 is a circuit diagram showing the structure of a conventional voltage detecting device having an equalizing function.

### DETAILED DESCRIPTION OF THE PREFERRED EMBODIMENT

In five preferred embodiments discussed in detail below with reference to drawings, the present invention is implemented in a battery system for a hybrid vehicle. A battery system having an assembled battery comprising 10 cells is described below, however, the present invention can be implemented in a battery system having an assembled battery comprising a plurality of cells the number of which is other than 10 as well. Also, the present invention can be implemented in a battery system having an assembled battery comprising a various kinds of secondary cells connected to each other in series other than lithium-ion secondary cells.

### FIRST EMBODIMENT

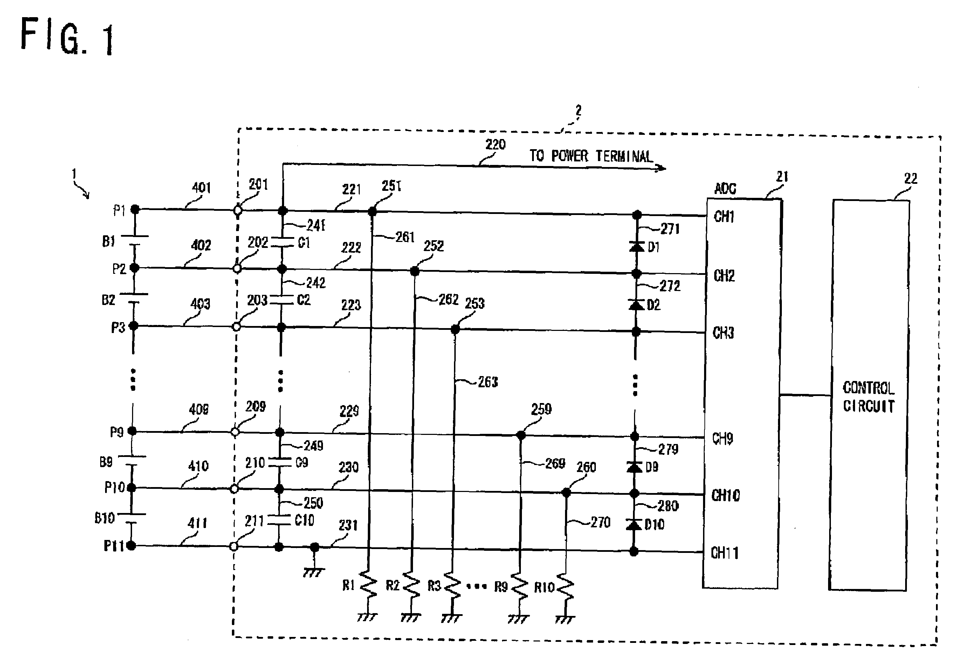

As shown in FIG. 1, a battery system according to a first embodiment comprises an assembled battery 1 comprising 10 lithium-ion secondary cells connected to each other in series, and a voltage detecting device 2 detecting the voltage across each of the cells. The assembled battery 1 has a positive electrode point P1, connecting points P2 to P10 between the cells, and a negative electrode point P11, The points P1 to P11 are respectively connected to 11 voltage input terminals 201 to 211 of the voltage detecting device 2 via wire harnesses 401 to 411. A power supply line (not shown) extends from each of the positive and negative electrodes of the assembled battery 1 to be connected to a load such as a drive motor.

In the voltage detecting device 2, voltage detecting lines 221 to 231 extend from the 11 voltage input terminals 201 to 211 respectively. Capacitors C1 to C10 for protecting circuits from static electricity voltage are respectively interposed on coupling lines 241 to 250 coupling two adjacent voltage detecting lines to each other. The capacitors C1 to C10 each has, for example, capacity of 0.1µF. Power source line 220 extends from the first voltage detecting line 221 of the 11 voltage detecting lines 221 to 231 to be connected to the power terminal (not shown) of the voltage detecting device 2. The 11th voltage detecting line 231 is connected to ground. The 11 voltage detecting lines 221 to 231 are connected to 11 input terminals of an ADC 21, and one output terminal of the ADC 21 is connected to a control circuit 22 comprising a micro computer.

The voltage detecting device 2 has a function of detecting a disconnection of the wire harness 401 to 411 between the voltage detecting points P1 to P11 of the assembled battery 1 and the voltage input terminals 201 to 211. On the voltage detecting lines 221 to 230 other than the 11th voltage detecting line 231 of the 11 voltage detecting lines 221 to 231, points 251 to 260 are located on the ADC 21 side of the capacitors C1 to C10. Current lines 261 to 270 extend from the points 251 to 260 respectively to be connected to ground. Disconnection detection resistors R1 to R10 each having a resistance value of around 200KΩ are interposed on the current lines 261 to 270 respectively.

Clamp diodes D1 to D10 are respectively interposed on coupling lines 271 to 280 each coupling two adjacent voltage detecting lines to each other on the ADC 21 side of the points 251 to 260. In other words, the coupling lines 271 to 280 are provided in parallel with the coupling lines 241 to 250 on which the capacitors C1 to C10 are respectively interposed. Each of the clamp diodes D1 to D10 is connected in the direction of the current flow from the voltage detecting line on the negative electrode side to the voltage detecting line on the positive electrode side.

In the voltage detecting device 2 described above, in the normal state where no disconnection has occurred on any wire harness, a current is supplied from the cells B1 to B10 to the capacitors C1 to C10 respectively to maintain each capacitor in a state where the charge is stored (fully charged state), thereby generating the positive or negative electrode potential of the cells B1 to B10 on the 11 voltage detecting lines 221 to 231 respectively. Then the potentials of the 11 voltage detecting lines 221 to 231 are respectively inputted into the 11 input terminals of the ADC 21. The ADC 21 converts the potential differences between two adjacent input terminals, i.e. the voltage across each cell, into digital voltage detecting data to output the data from the output terminal. The control circuit 22 monitors whether the cells are not overcharged or overdischarged based on the voltage detecting data of the 10 cells obtained from the output terminal of the ADC 21.

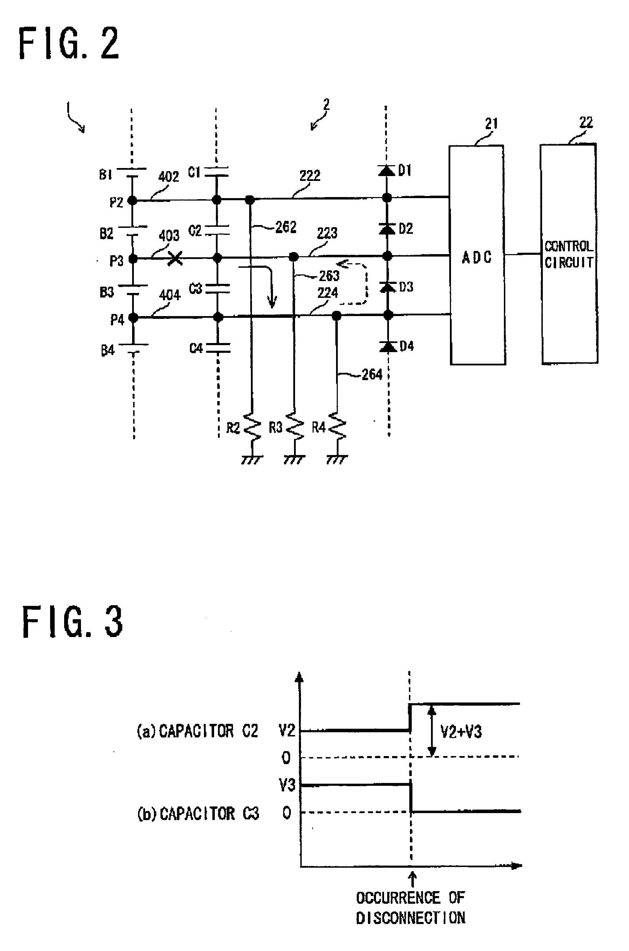

For example, in the case where a disconnection occurs on the third wire harness 403 between the third voltage detecting point P3 of the assembled battery 1 and the third voltage input terminal (not shown) of the voltage detecting device 2 as indicated by a cross mark in the FIG. 2, the current stops being supplied from the cell B3 to the capacitor C3. Then the stored charge is discharged from the capacitor C3 and flows into ground via the third voltage detecting line 223, the third current line 263 and the disconnection detection resistor R3 as indicated by a solid arrow in the figure, and then, the potential of the third voltage detecting line 223 gradually decreases. When the potential of the third voltage detecting line 223 becomes equal to the potential of the fourth voltage detecting line 224 in this process, the current starts flowing from the fourth voltage detecting line 224 into the third voltage detecting line 223 via the clamp diode D3, as indicated by a dashed arrow in the figure. Therefore, the potential of the third voltage detecting line 223 does not fall below the potential of the fourth voltage detecting line 224, whereby the potential difference of both voltage detecting lines 223, 224 i.e. the voltage across the capacitor C3 becomes nearly zero. Also, since the voltage across the capacitor C3 becomes nearly zero, the voltage across the capacitor C2 becomes equal to the sum voltage of cells B2 and B3.

FIG. 3 shows the change of the voltages across two capacitors C2, C3 when a disconnection occurs on the third wire harness 403. Here, the voltages across two cells B2, B3 at the time of occurrence of the disconnection are V2, V3 respectively.

The voltage across the capacitor C3 before the occurrence of a disconnection is equal to the voltage V3 across the cell B3 as shown in FIG. 3(b), however, when a disconnection occurs, it becomes nearly zero. On the other hand, the voltage across the capacitor C2 before the occurrence of a disconnection is equal to the voltage V2 across the cell B2 as shown in FIG. 3(a), however, when a disconnection occurs, it becomes equal to the sum voltage of the cells B2 and B3 (=V2+v3).

As described above, when the disconnection occurs on the n-th wire harness (1≦n≦10), the voltage across the n-th capacitor Cn becomes nearly zero, and thus the voltage across the n-th cell to be inputted into the control circuit 22 becomes nearly zero. In the actual usage range of the lithium-ion secondary cell, it is not possible for the voltage across the cell to fall below the voltage value when the charging capacity is zero. Therefore, the control circuit 22 shown in FIG. 1 monitors the voltage across each cell inputted from the ADC 21, and when the voltage across the n-th cell falls to a predetermined threshold value, it determines that a disconnection has occurred on the n-th wire harness. Here, the threshold value is set for each cell, and is set to the value equal to or below the voltage across each cell at the time the charging capacity is zero. It is possible to set the threshold values for all cells to zero.

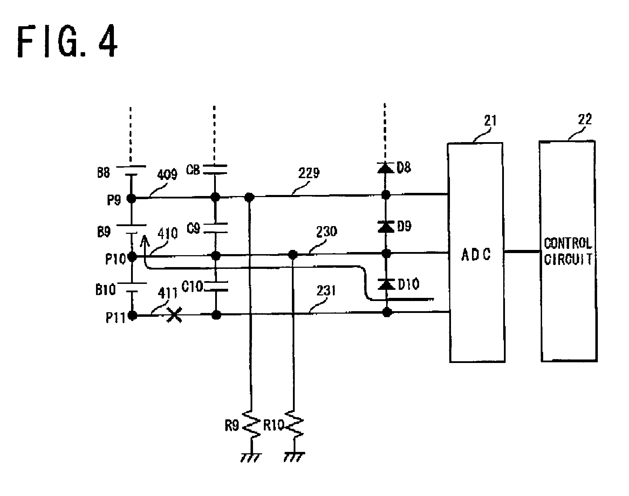

In the case of occurrence of a disconnection on the 11th wire harness 411, the current flows as indicated by an arrow in FIG. 4, and the voltage across the capacitor C10 becomes nearly zero. Therefore, when the voltage across the cell B10 falls to the predetermined threshold value, it is determined that a disconnection has occurred on the 11th wire harness 411.

In a configuration in which the clamp diodes D1 to D10 are not provided between two voltage detecting lines, for example, in the case of occurrence of a disconnection on the third wire harness 403 as described above, the potential of the third voltage detecting line 223 falls below the potential of the fourth voltage detecting line 224. Then a voltage of opposite electrode is applied between the third channel input terminal CH3 and the fourth channel input terminal CH4 of the ADC 21, while a high voltage is applied between the third channel input terminal CH3 and the second channel input terminal CH2 of the ADC 21.

On the other hand, in the voltage detecting device 2 described above, since the clamp diode D3 is interposed between the third voltage detecting line 223 and the fourth voltage detecting line 224 with its forward direction facing the positive electrode side of the assembled battery 1, the potential of the third voltage detecting line 223 does not fall below the potential of the fourth voltage detecting line 224 as described above. Therefore, a voltage of opposite electrode is not applied between the third channel input terminal CH3 and the fourth channel input terminal CH4 of the ADC 21, nor is a high voltage applied between the third channel input terminal CH3 and the second channel input terminal CH2 of the ADC 21.

Thus, by providing the clamp diodes D1 to D10 between two adjacent voltage detecting lines with their forward direction facing the positive electrode side of the assembled battery 1, it is possible to prevent a voltage of opposite electrode and a high voltage from being applied to the ADC 21.

In the battery system according to this embodiment, in the normal state where no disconnection has occurred, no matter how much the states of charge of the plurality of cells forming the assembled battery 1 vary, the potential difference of two adjacent voltage detecting lines does not fall below the predetermined threshold value to become nearly zero. Therefore, it is not possible that the occurrence of a disconnection is erroneously determined when no disconnection has occurred.

### SECOND EMBODIMENT

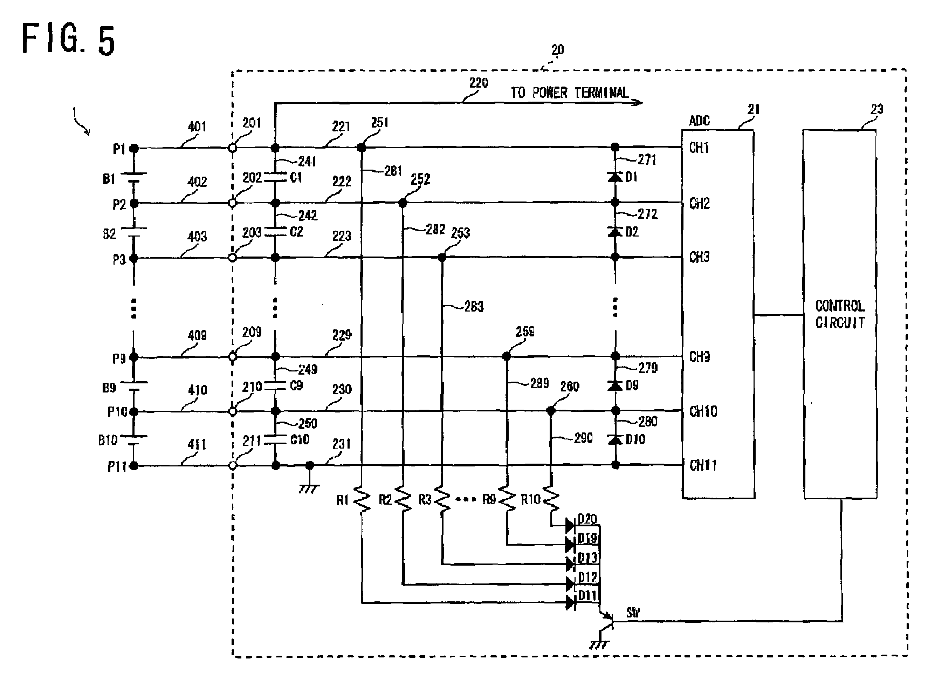

As shown in FIG. 5, a battery system of this embodiment comprises an assembled battery 1 comprising 10 lithium-ion secondary cells connected to each other in series, and a voltage detecting device 20 detecting the voltage across each of the cells in the similar manner to the first embodiment. The assembled battery 1 has a positive electrode point P1, connecting points P2 to P10 between the cells, and a negative electrode point P11. The points P1 to P11 are respectively connected to 11 voltage input terminals 201 to 211 of the voltage detecting device 20 via wire harnesses 401 to 411. A power supply line (not shown) extends from each of the positive and negative electrodes of the assembled battery to be connected to a load such as a drive motor.

The voltage detecting device 20 has 11 voltage detecting lines 221 to 231. Current lines 281 to 290 respectively extend from the points 251 to 260 on the voltage detecting lines 221 to 230 other than the 11th voltage detecting line 231. The points 251 to 260 are located on the ADC 21 side of the capacitors C1 to C10. The 10th current line 290 of the 10 current lines 281 to 290 is connected to ground via a disconnection detection ON/OFF switching element SW, while the other nine current lines 281 to 289 are connected to the 10th current line 290. The disconnection detection ON/OFF switching element SW is controlled ON/OFF by a control circuit 23.

Disconnection detection resistors R1 to R10 each having a resistance value of, for example, around 200KΩ as well as diodes D11 to D20 are interposed on the current lines 281 to 290 respectively. The diodes D11 to D20 are connected in the direction of the current flow from the voltage detecting lines 221 to 230 to the ground. Thus, it is possible to prevent the current from flowing reversely from the current line having higher voltage to the current line having lower voltage. The description of other structures and actions is omitted since they are the same as in the first embodiment.

In the battery systems for hybrid vehicles, the assembled battery is not charged or discharged in the state where the ignition switch is OFF. Therefore, it is not necessary to monitor the voltage across each of the cells forming the assembled battery, and the power of the voltage detecting device is set OFF.

In the battery system of this embodiment, in the state where the disconnection detection ON/OFF switching element SW of the voltage detecting device 20 is ON, a small amount of current flows from each of the cells B1 to B10 forming the assembled battery 1 into ground via the voltage detecting lines 221 to 230 and the disconnection detection resistors R1 to R10. Therefore, if the switching element SW is set to ON in the state where the power of the voltage detecting device 20 is OFF and thus it is not possible to detect a disconnection, the electric power of the cells will be consumed wastefully. In view of this, the control circuit 23 described above sets the disconnection detection ON/OFF switching element SW to ON when the ignition switch is set to ON and thereby the power of the voltage detecting device 20 is set to ON. Thus, it is possible to prevent the electric power of the cells from being consumed wastefully by setting the disconnection detection ON/OFF switching element SW to ON only in the state where the power of the voltage detecting device is ON.

### THIRD EMBODIMENT

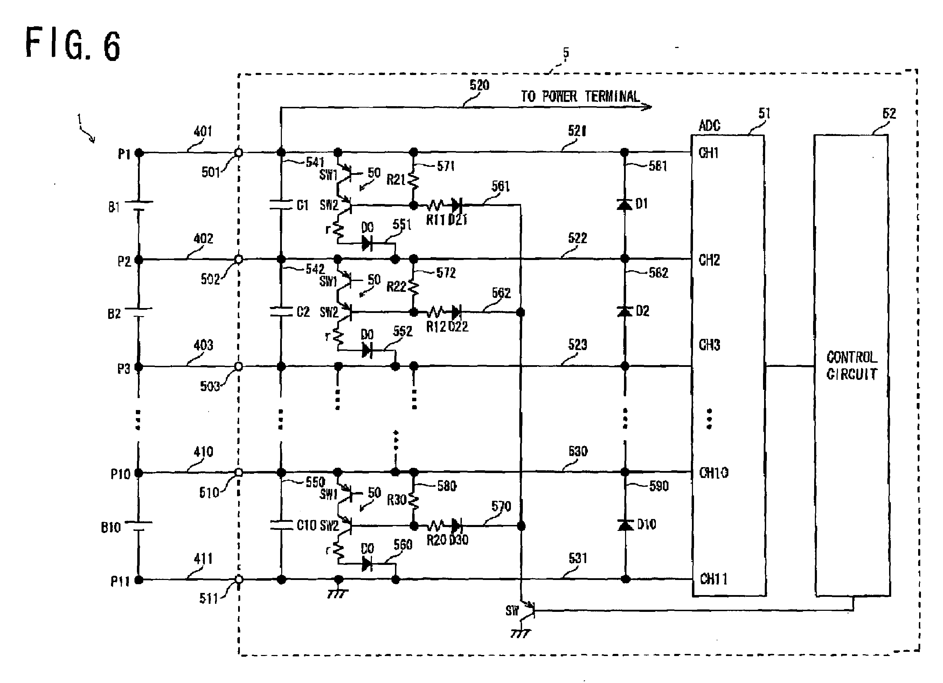

As shown in FIG. 6, a battery system of this embodiment comprises an assembled battery 1 comprising 10 lithium-ion secondary cells connected to each other in series, and a voltage detecting device 5 detecting the voltage across each of the cells. The assembled battery has a positive electrode point P1, connecting points P2 to P10 between the cells, and a negative electrode point P11. The points P1 to P11 are respectively connected to 11 voltage input terminals 501 to 511 of the voltage detecting device 5 via wire harnesses 401 to 411. A power supply line (not shown) extends from each of the positive and negative electrodes of the assembled battery to be connected to a load such as a drive motor.

In the voltage detecting device 5, voltage detecting lines 521 to 531 extend from the 11 voltage input terminals 501 to 511 respectively. Capacitors C1 to C10 for protecting circuits from static electricity voltage are respectively interposed on coupling lines 541 to 550 coupling two adjacent voltage detecting lines to each other. The capacitors C1 to C10 each has, for example, a capacity of 0.1µF. Power source line 520 extends from the first voltage detecting line 521 of the 11 voltage detecting lines 521 to 531 to be connected to the power terminal (not shown) of the voltage detecting device 5. The 11th voltage detecting line 531 is connected to ground. An ADC 51 has 11 input terminals to which the 11 voltage detecting lines 521 to 531 are connected and one output terminal connected to a control circuit 52 comprising a micro computer.

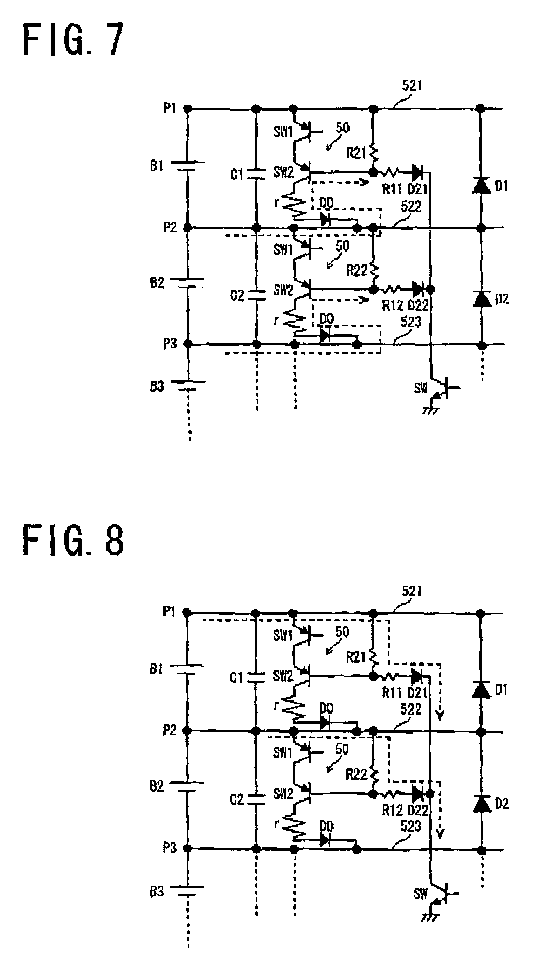

The voltage detecting device 5 has a function of equalizing the states of charge of the cells forming the assembled battery 1. A discharging circuit 50 is interposed on coupling lines 551 to 560 coupling two adjacent voltage detecting lines to each other on the ADC 51 side of the capacitors C1 to C10. The coupling lines 551 to 560 are provided in parallel with the coupling lines 541 to 550 on which the capacitors C1 to C10 are respectively interposed, The discharging circuit 50 comprises two switching elements SW1, SW2 each consisting of a transistor, an equalizing resistor r, and a diode D0 connected to each other in series. Here, the equalizing resistor r has, for example, a resistance value of around 100Ω. Each diode D0 is connected in the direction of the current flow from the voltage detecting line on the positive electrode side to the voltage detecting line on the negative electrode side, thereby preventing the current from flowing in the direction indicated by dashed arrows in FIG. 7 in the event of disconnection of the wire harness.

Current lines 561 to 570 each extends from the base of one switching element SW2 of the two switching elements SW1, SW2 of each discharging circuit 50 shown in FIG. 6. Among the 10 current lines 561 to 570, the first current line 561 is connected to ground via a disconnection detection ON/OFF switching element SW, and the other nine currents lines 562 to 570 are connected to the first current line 561. The disconnection detection ON/OFF switching element SW is controlled ON/OFF by the control circuit 52.

First switching control/disconnection detection resistors R11 to R20 and diodes D21 to D30 are interposed on the current lines 561 to 570 respectively. Second switching control/disconnection detection resistors R21 to R30 are interposed on coupling lines 571 to 580 each coupling an end of the first switching control/disconnection detection resistor on the discharging circuit 50 side and each of the voltage detecting lines 521 to 530 located on the positive electrode side of the discharging circuit 50 to each other, on the ADC 51 side of the discharging circuit 50. The first switching control/disconnection detection resistors R11 to R20 each has, for example, a resistance value of around 200KΩ, while the second switching control/disconnection detection resistors R21 to R30 each has, for example, a resistance value of around 50KΩ, The diodes D21 to D30 are connected in the direction of the current flow from the switching element SW2 to the ground, thereby preventing the current from flowing reversely from the current line having higher voltage to the current line having lower voltage.

Clamp diodes D1 to D10 are respectively interposed on coupling lines 581 to 590 each coupling two adjacent voltage detecting lines to each other on the ADC 51 side of the second switching control/disconnection detection resistors R21 to R30. The coupling lines 581 to 590 are provided in parallel with the coupling lines 541 to 550 on which the capacitors C1. to C10 are respectively interposed. The clamp diodes D1 to D10 are connected in the direction of the current flow from the voltage detecting line on the negative electrode side to the voltage detecting line on the positive electrode side.

In the similar manner to the conventional discharging circuit 80 shown in FIG. 22, first switching control resistors R31 to 40, second switching control resistors R41 to R50, and a discharge ON/OFF switching element SW20 (all not shown) are connected to the base of the switching element SW1 of the discharging circuit 50 respectively, and the discharge ON/OFF switching element SW20 is controlled ON/OFF by the control circuit 52. When the discharge ON/OFF switching element SW20 is set to ON, the switching element SW1 of the discharging circuit 50 becomes ON.

In the battery system of this embodiment, the control circuit 52 sets the disconnection detection ON/OFF switching element SW to ON when the ignition switch (not shown) is set to ON and thereby the power of the voltage detecting device 5 is set to ON. A current thereby starts being supplied from each of the cells B1 to B10 to each of the capacitors C1 to C10 to maintain each capacitor in a state where the charge is stored (fully charged state), and a small amount of current starts flowing from the cells B1 to B10 into ground via the voltage detecting lines 521 to 530, the second switching control/disconnection detection resistors R21 to R30, the first switching control/disonnection detection resistors R11 to R20, the diodes D21 to D30, and the disconnection detection ON/OFF switching element SW respectively, as indicated by dashed arrows in FIG. 8.

In the normal state where no disconnection has occurred on any of the wire harnesses 401 to 411, the capacitors C1 to C10 are maintained in the fully charged state as described above, thereby generating the positive or negative electrode potential of the cells B1 to B10 on the voltage detecting lines 521 to 531 respectively. Then the potentials of the 11 voltage detecting lines 521 to 531 are respectively inputted into the 11 input terminals of the ADC 51. The APC 51 converts the potential differences between two adjacent input terminals, i.e. the voltage across each cell, into digital voltage detecting data to output the data from the output terminal. The control circuit 52 monitors whether the cells are not overcharged or overdischarged based on the voltage detecting data of the 10 cells obtained from the output terminal of the ADC 51.

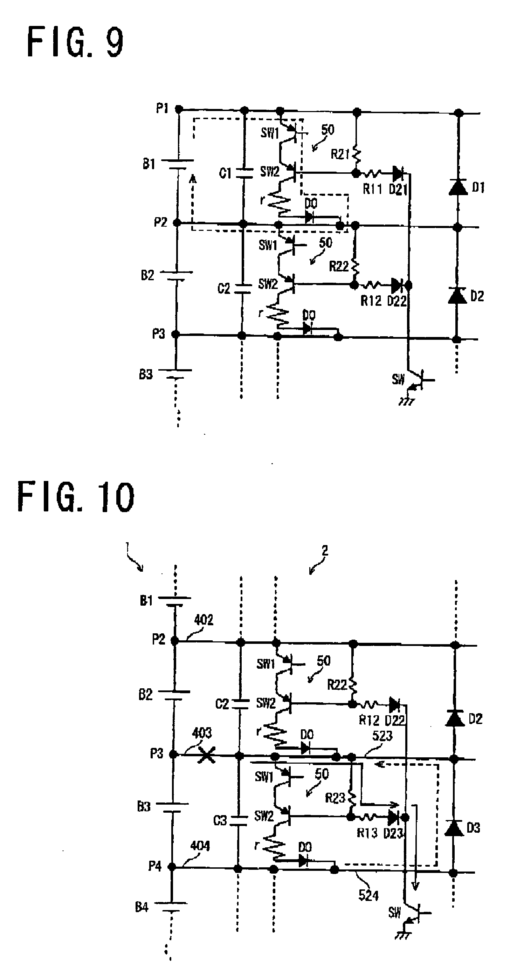

In the equalizing process by the voltage detecting device 5 described above, the cell having a voltage thereacross exceeding an equalization target voltage is discharged by the discharging circuit 50. In the state where the disconnection detection ON/OFF switching element SW is set ON and a small current flows from each cell toward the ground as described above, when the switching element SW1 of the discharging circuit 50 connected to the cell to be discharged is set to ON, the switching element SW2 also becomes ON and the cell starts being discharged. For example, when the switching element SW1 of the discharging circuit 50 connected to the cell B1 is set to ON, the current starts flowing from the cell B1 to the switching elements SW1, SW2, the equalizing resistor r, and the diode D0 as indicated by a dash arrow in FIG. 9, to discharge the cell B1. Thus, the states of charge of the cells can be equalized by discharging the cell having a voltage thereacross exceeding the equalization target voltage.

Furthermore, for example, in the case of occurrence of a disconnection on the third wire harness 403 between the third voltage detecting point P3 of the assembled battery 1 and the third voltage input terminal (not shown) of the voltage detecting device 5 as indicated by a cross mark in FIG. 10, the current stops being supplied from the cell B3 to the capacitor C3. Then the stored charge is discharged from the capacitor C3 and flows into ground via the third voltage detecting line 523, the second switching control/disconnection detection resistor R23, the first switching control/disconnection detection resistor R13, the diode D23, and the disconnection detection ON/OFF switching element SW as indicated by solid arrows in the figure, and then, the potential of the third voltage detecting line. 523 gradually decreases. When the potential of the third voltage detecting line 523 becomes equal to the potential of the fourth voltage detecting line 524 in this process, the current starts flowing from the fourth voltage detecting line 524 into the third voltage detecting line 523 via the clamp diode D3, as indicated by a dashed arrow in the figure. Therefore, the potential of the third voltage detecting line 523 does not fall below the potential of the fourth voltage detecting line 524, whereby the potential difference of both voltage detecting lines 523 and 524 i.e. the voltage across the capacitor C3 becomes nearly zero. Also, since the voltage across the capacitor C3 becomes nearly zero, the voltage across the capacitor C2 becomes equal to the sum voltage of cells B2 and B3.

Here, in a similar manner to the first embodiment, it is possible to prevent a voltage of opposite electrode and a high voltage from being applied to the RDC 51 by providing the cramp diodes D1 to D10 between two adjacent voltage detecting lines with their forward direction facing the positive electrode side of the assembled battery 1.

As described above, when a disconnection occurs on the n-th wire harness (1≦n≦10), the voltage across the n-th capacitor Cn becomes nearly zero, and thus the voltage across the n-th cell to be inputted into the control circuit 52 becomes nearly zero. In the actual usage range of the lithium-ion secondary cell, it is not possible for the voltage across the cell to fall below the voltage value at the time the charging capacity is zero. Therefore, the control circuit 52 shown in FIG. 6 monitors the voltage across each cell inputted from the ADC 51, and when the voltage across the n-th cell falls to a predetermined threshold value, it determines that a disconnection has occurred on the n-th wire harness. Here, the threshold value is set for each cell, and is set to the value equal to or below the voltage across each cell at the time the charging capacity of the cell is zero. It is possible to set the threshold values for all cells to zero.

In the case of occurrence of a disconnection on the 11th wire harness 411, the voltage across the capacitor C10 becomes nearly zero. Therefore, when the voltage across the cell B10 falls to the predetermined threshold value, it is determined that a disconnection has occurred on the 11th wire harness 411.

In the battery system of this embodiment, in the normal state where no disconnection has occurred, no matter how much the states of charge of the plurality of cells forming the assembled battery 1 vary, the potential difference of two adjacent voltage detecting lines does not fall below the predetermined threshold value to become nearly zero. Therefore, it is not possible that the occurrence of a disconnection is erroneously determined when no disconnection has occurred.

Also, since the disconnection detection ON/OFF switching element SW is set to ON only in the state where the power of the voltage detecting device 5 is ON, it is possible to prevent the electric power of the cells from being consumed wastefully in the similar manner to the second embodiment.

Further, in the battery system including a switching element with only one discharging circuit, in the event of a stuck-ON fault which causes the switching element to be permanently ON, the cell connected to the discharging circuit having the stuck-ON fault is permanently discharged by said discharging circuit. When the stuck-ON fault occurs on the switching element of the discharging circuit with the ignition switch set OFF, the capacity of the cell falls below the predetermined capacity, causing such a situation that the engine does not start even when the ignition switch is set to ON thereafter. In the battery system of this embodiment, there is very small possibility that the stuck-ON fault occurs on both two switching elements SW1, SW2 at the same time, and there is very small possibility that the situation described above arises due to the occurrence of the stuck-ON fault on both two switching elements SW1, SW2 at the same time. In the state where the ignition switch is OFF, even when the stuck-ON fault occurs on the switching element SM1 of the discharging circuit 50, since the disconnection detection ON/OFF switching element SW is set OFF, the switching element SW2 of the discharging circuit 50 does not become ON. Therefore, the situation described above does not arise. Also, even when the stuck-ON fault occurs on the switching element SW2 of the discharging circuit 50, since the switching element SW1 is set OFF, the situation described above does not arise.

Furthermore, in the voltage detecting device 5 of this embodiment, the switching control/disconnection detection resistors R11 to R20, R21 to R30 are used far both disconnection detection and switching control for the switching element SW2 of the discharging circuit 50. Therefore, the device has the smaller number of elements and simpler structure compared to the structure having a switching control resistor and disconnection detection resistor separately.

### FOURTH EMBODIMENT

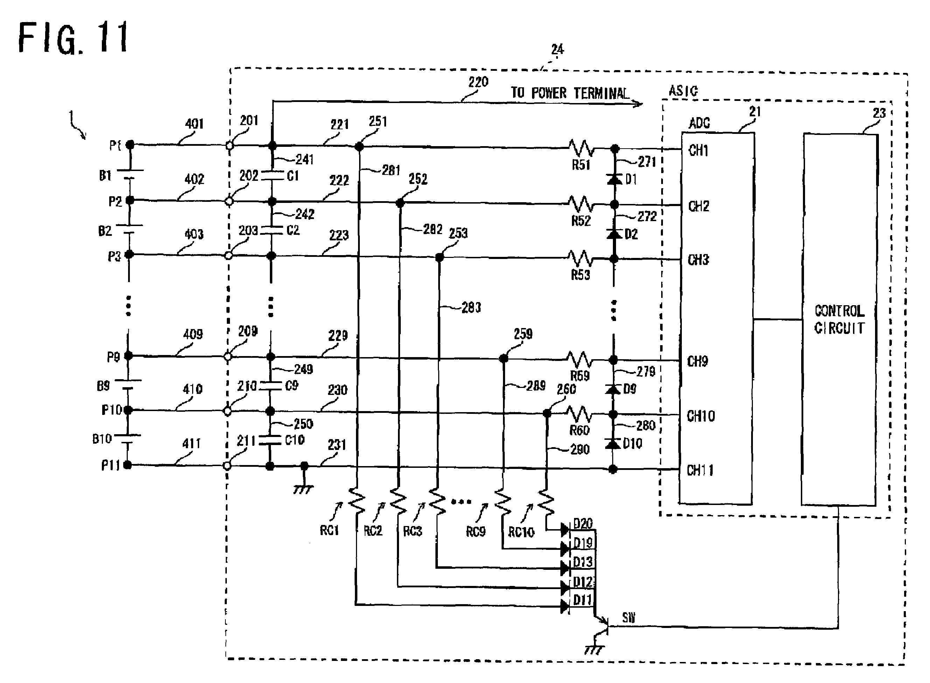

As shown in FIG. 11, a battery system of this embodiment comprises an assembled battery 1 comprising 10 lithium-ion secondary cells connected to each other in series, and a voltage detecting device 24 detecting the voltage across each of the cells. The assembled battery has a positive electrode point P1, connecting points P2 to P10 between the cells, and a negative electrode point P11. The points P1 to P11 are respectively connected to 11 voltages input terminals 201 to 211 of the voltage detecting device 24 via wire harnesses 401 to 411. A power supply line (not shown) extends from each of the positive and negative electrodes of the assembled battery to be connected to a load such as a drive motor.

In the voltage detecting device 24, on current lines 281 to 290 respectively extending from points 251 to 260 on voltage detecting lines 221 to 230 other than a 11th voltage detecting line 231, interposed are diodes D11 to D20 and disconnection detection resistance circuits RC1 to RC10 each comprising a plurality of resistors (only one resistor is shown in FIG. 11) connected to each other in series, Also, an ADC 21 and a control circuit 23 form an ASIC (Application Specific Integrated Circuit). Protective resistors R51 to R60 for preventing an overcurrent from flowing in the ASIC in the case of short circuit are interposed on the voltage detecting lines 221 to 230 other than a 11th current line 231 between the points 251 to 260 and coupling points coupling the voltage detecting lines to coupling lines 271 to 280 having clamp diodes D1 to D10 interposed thereon. The protective resistors R51 to R60 each has, for example, a resistance value of around 5kΩ. Other structures are the same as in the voltage detecting device of the second embodiment.

The following is the reason for disposing the protective resistors R51 to R60 on the ASIC side of the current lines 281 to 290 having the disconnection detection resistance circuits RC1 to RC10 interposed thereon as described above.

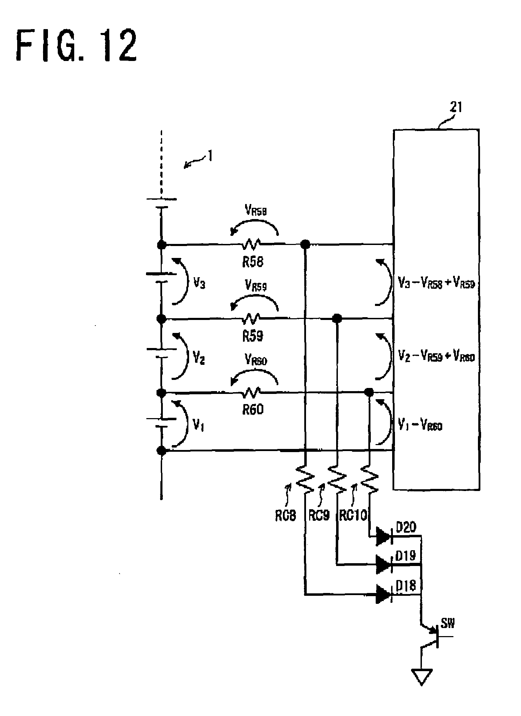

FIG. 12 shows the structure of part of the battery system in which the protective resistors are disposed on the assembled battery 1 side of the current lines having the disconnection detection resistance circuits interposed thereon. Where the voltages across three cells at the end of the assembled battery 1 on the negative electrode side are V₁, V₂, and V₃ respectively, while the voltage drop amounts due to the protective resistors R58, R59, and R60 are V_{R58}, V_{R59}, and V_{R60}, respectively as shown in the figure, the voltages across the cells detected by the ADC 21 are V₁-V_{R60}, V₂-V_{R59}+V_{R60}, V₃-V_{R58}V_{R59}. And the voltage across each cell detected by the ADC 21 has an error due to the protective resistors. In the state where the disconnection detection ON/OFF switching element SW is ON, a small amount of current flows from the cells into ground via the protective resistors R51 to R60 and the disconnection detection resistance circuits RC1 to RC10 respectively. Here, the magnitude of the current flowing from the cells into ground varies, and therefore, the voltage drop amounts Vₖ₅₁ to V_{R60} due to the protective resistors R51 to R60 vary. Thus, for example, when the variation range of the current flowing in the disconnection detection resistance circuits RC1 to RC10 is 10µA, the voltage drop amounts due to the protective resistors R51 to R60 vary with the variation range of 50mA (=5kΩ×10µA). Therefore, the errors caused in the voltages across each cell detected by the ADC 21 vary, and thereby the accuracy of the voltage detection is low. In view of this, as shown in FIG. 11, the protective resistors R51 to R60 are disposed on the ASIC side of the current lines 281 to 290 having the disconnection defection resistance circuits RC1 to RC10 interposed thereon.

According to the battery system of this embodiment, by disposing the protective resistors R51 to R60 on the ASIG side of the disconnection detection resistance circuits RC1 to RC10 as described above, it is possible to prevent an overcurrent from flowing in the ASIC in the case of short circuit, as well as to obtain the accuracy of the voltage detection as high as in the voltage detecting device without protective resistors R51 to R60.

It is also possible to set the resistance values of the disconnection detection resistance circuits RC1 to RC10 of this embodiment so that they have greater combined resistance values as they are connected to the voltage detecting lines closer to the positive electrode of the assembled battery 1, in order for the consumption currents of the cells forming the assembled battery 1 to be substantially the same. The reason of this resistance value setting is as follows.

In the state where the disconnection detection ON/OFF switching element SW is ON, a small amount of current flows from each of the cells B1 to B10 into ground via the disconnection detection resistance circuits RC1 to RC10. Here, the current flows from the cell B1 only into the disconnection detection resistance circuit RC1, from the cell B2 into the disconnection detection resistance circuits RC1 and RC2, from the cell B3 into the disconnection detection resistance circuits RC1, RC2 and RC3, ...and from the cell B10 into the disconnection detection resistance circuits RC1 to RC10. Therefore, the consumption currents of the cells vary, whereby the voltages across the cells vary. Therefore, the resistance values of the disconnection detection resistance circuits RC1 to RC10 of this embodiment are set so that they have greater combined resistance values as they are connected to the voltage detecting lines closer to the positive electrode of the assembled battery 1.

Also, it is preferable to connect a plurality of resistors to each other in series to form the disconnection detection resistance circuits RC1 to RC10. The reason is as follows.

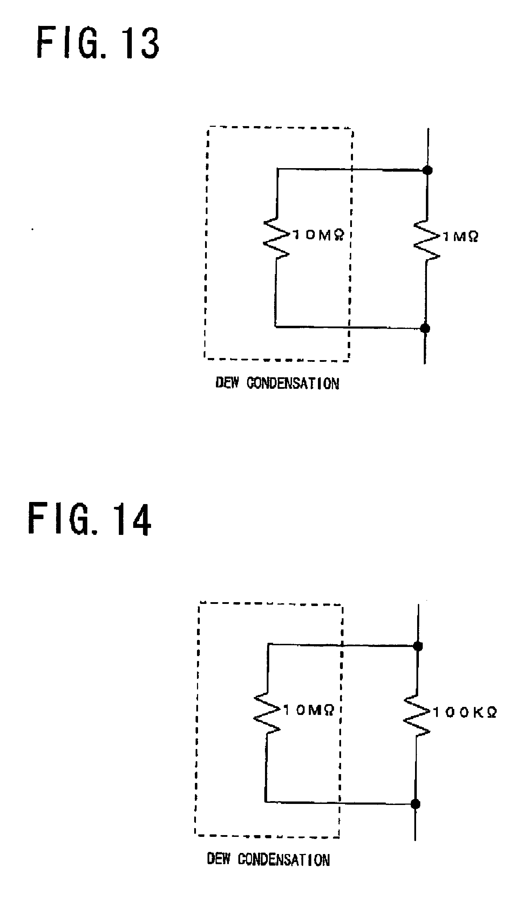

In the case where dew condensation is generated, or sulfidizing gas or chlorine gas adsorbs on the resistors on a base plate, the resistance value of the resistor on the base plate falls to around the combined resistance value of resistors having a resistance value of around 10MΩ connected in parallel as shown in FIGS. 13 and 14. For example, in the case of generation of dew condensation on a resistor having a resistance value of 1MΩ as shown in FIG. 13, the resistance value falls to around 900kΩ (combined resistance value of 1MΩ and 10MΩ). On the other hand, in the case of generation of dew condensation on a resistor having a resistance value of 100kΩ as shown in FIG. 14, the resistance value falls to around 99kΩ (combined resistance value of 100kΩ and 10MΩ). Thus, the smaller the resistance value of the adopted resistor is, the smaller the drop amount of the resistance value due to dew condensation is. In view of this, since the variety of the combined resistance values of the disconnection detection resistance circuits RC1 to RC10 may be maintained small by connecting a plurality of resistors to each other in series to form the disconnection detection resistance circuit, it is possible to maintain the variety of the current flowing into ground via the disconnection detection resistance circuits RC1 to RC10 due to the dew condensation or the like small. Therefore, the variety of voltages across the cells may be maintained small.

### FIFTH EMBODIMENT

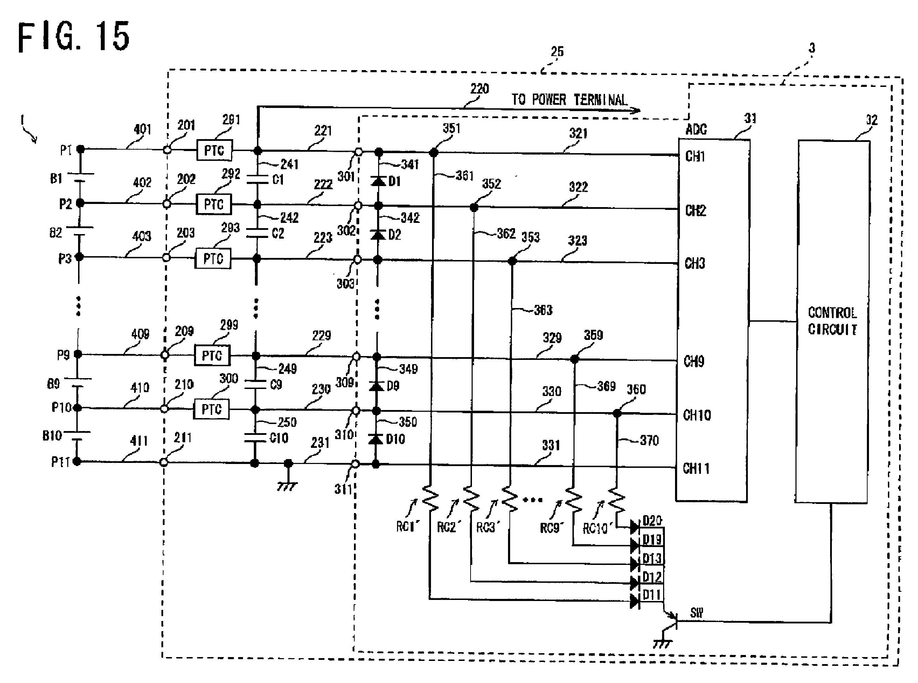

As shown in FIG. 15, a battery system of this embodiment comprises an assembled battery 1 comprising 10 lithium-ion secondary cells connected to each other in series, and a voltage detecting device 25 detecting the voltage across each of the cells. The assembled battery 1 has a positive electrode point P1, connecting points P2 to P10 between the cells, and a negative electrode point P11. The points P1 to P11 are respectively connected to 11 voltage input terminals 201 to 211 of the voltage detecting device 25 via wire harnesses 401 to 411. A power supply line (not shown) extends from each of the positive and negative electrodes of the assembled battery to be connected to a load such as a drive motor.

In the voltage detecting device 25, 11 voltage detecting lines 221 to 231 are connected to 11 voltage input terminals 301 to 311 of an ASIC 3. Also, PTC elements 291 to 300 are respectively interposed on the voltage detecting lines 221 to 230 other than the 11th voltage detecting line 231 on the voltage input terminals 201 to 210 side of the capacitors C1 to C10. In the case where a short circuit occurs in the ASIC 3 and thereby an overcurrent flows in the voltage detecting lines, the PTC elements generate heat to increase the electric resistance value sharply. As a result, the overcurrent flowing in che voltage detecting lines is blocked by the PTC elements. Thus, it is possible to prevent an overcurrent from flowing in the ASIC 3.

In the ASIC 3, voltage detecting lines 321 to 331 extend from the 11 voltage input terminals 301 to 311 to be connected to the 11 input terminals of an ADC 31, and one output terminal of the ADC 31 is connected to a control circuit 32 comprising a micro computer.

Current lines 361 to 370 respectively extend from points 351 to 360 on the voltage detecting lines 321 to 330 other than the 11th voltage detecting line 331 of the 11 voltage detecting lines 321 to 331. Among the 10 current lines 361 to 370, the 10th current line 370 is connected to ground via a disconnection detection ON/OFF switching element SW, while the other nine current lines 361 to 369 are connected to the 10th current line 370. The switching element SW is controlled ON/OFF by the control circuit 32. On the current lines 361. to 370, interposed respectively are disconnection detection resistance circuits RC1' to RC10' comprising a plurality of resistors (only one resistor is shown in FIG. 15) connected to each other in series and diodes D11 to D20. The disconnection detection resistance circuits RC1' to RC10' each comprises a resistor having a great resistance value of around 1MΩ. The disconnection detection resistance circuits RC1' the closest to the positive electrode of the assembled battery 1 has, for example, a resistance value of 4.3MΩ.

Clamp diodes D1 to D10 are respectively interposed on coupling lines 341 to 350 each coupling two adjacent voltage detecting lines to each other on the voltage input terminals 301 to 310 side of the points 351 to 360. Other structures are the same as in the voltage detecting device of the second embodiment.

In the battery system of this embodiment, although the PTC elements 291 to 300 are disposed on the voltage input terminals 301 to 311 side of the current lines 361 to 370 having the disconnection detection resistance circuits RC1' to RC10' interposed thereon, the resistance value of each PTC element is a few Ω in the normal state, and thus, the amount of voltage drop due to the PTC elements is a negligible amount. For example, in the case where a current of 0.1mA flows in the disconnection detection resistance circuit, the amount of voltage drop due to the PTC element is equal to or below 1mV. Therefore, it is possible to prevent an overcurrent from flowing in the ASIC 3 in the case of short circuit in the ASIC 3 as well as to obtain the voltage detection accuracy as high as in a voltage detecting devices without the PTC elements 291 to 300. In addition, the PTC element may be replaced with a protection element having a small resistance value such as fuse.

Also, in the battery system of this embodiment, since the ASIC 3 has a disconnection detection circuit built therein including the disconnection detection resistance circuits RC1' to RC10', the diodes D11 to D20, and the disconnection detection ON/OFF switching element SW, the voltage detecting device can be smaller than that in the battery system provided with a disconnection detection circuit as an external circuit of the ASIC, resulting in the decrease in size of the system itself.

Further, in the battery system of this embodiment, since the disconnection detection resistance circuits RC1' to RC10' are housed in a package constituting the ASIC 3, these resistors do not have the generation of dew condensation or the adsorption of sulfidizing gas or chlorine gas thereon. Since these resistors do not have the generation of dew condensation or the adsorption of sulfidizing gas or chlorine gas thereon, resistors having great resistance values may be used. Therefore, it is possible to form the disconnection detection resistance circuits RC1' to RC10' having an adequately great resistance values by using fewer resistors each having a great resistance value as described above. Thus it is possible to maintain the variety of the voltages across the cells small as well as maintaining the size of the circuit of the ASIC 3 small.

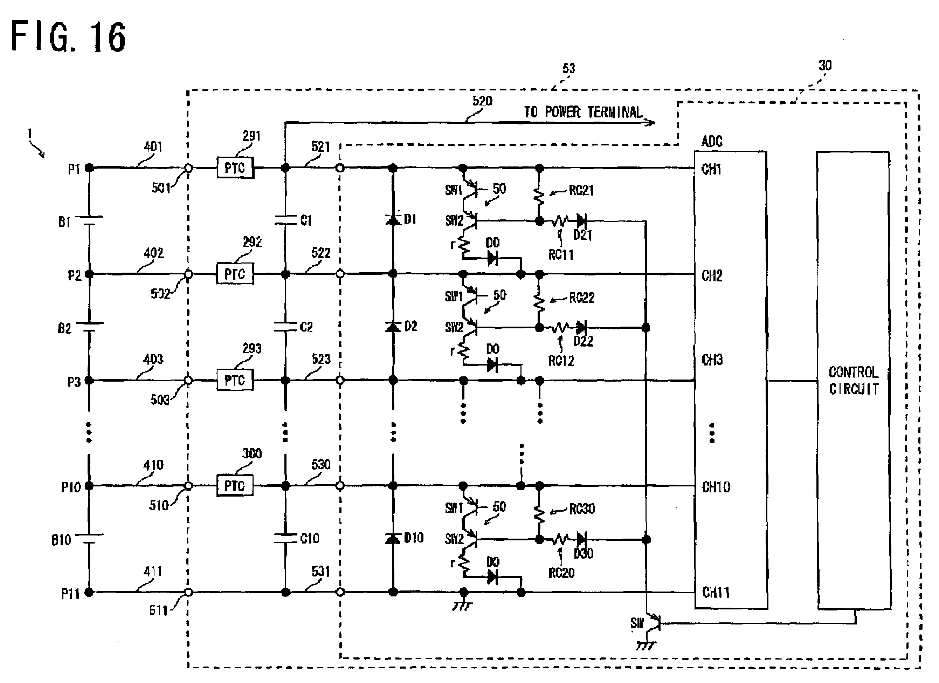

FIG. 16 shows a modification of the battery system of the third embodiment, wherein PTC elements 291 to 300 are interposed on the voltage detecting lines 521 to 530 other than the 11th voltage detecting line 531 on the voltage input terminals 501 to 510 side of the capacitors C1 to C10, and disconnection detection circuit including switching control/disconnection detection resistance circuits RC11 to RC20 and RC21 to RC30 comprising a plurality of resistors (only one resistor is shown in FIG. 16) connected to each other in series, discharging circuits 50, and the clamp diodes D1 to D10 are provided within the ASIC 30.

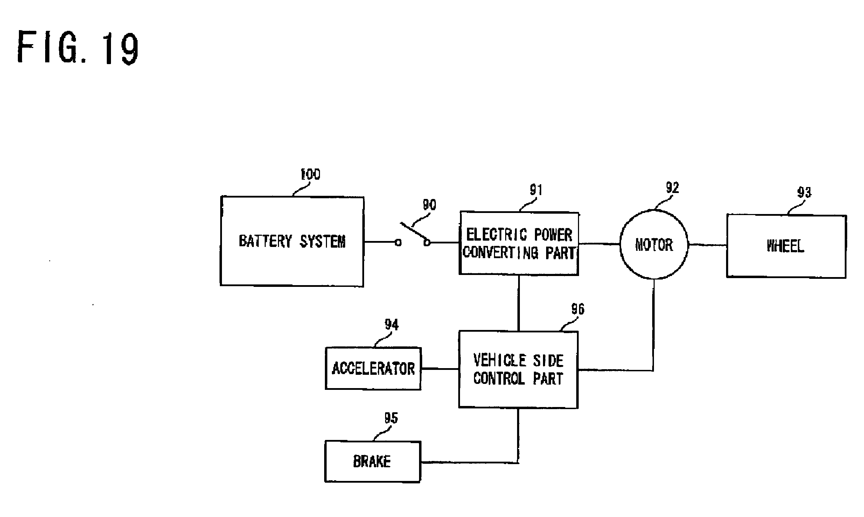

FIG. 19 shows the structure of the electric vehicle according to the present invention, in which the electric power obtained from a battery system 100 is supplied to a motor 92 via an electric power converting part 91 to drive the motor 92, thereby driving a wheel 93. A torque command corresponding to the operation amount of an accelerator 94 and a brake 95 as well as the number of rotation of the motor 92 are supplied to a vehicle side control part 96, and the operation of the electric power converting part 91 is controlled by the vehicle side control part 96. A contactor 90 is interposed between the battery system 100 and the electric power converting part 91. The contactor 90 is controlled ON/OFF by a control circuit (not shown) constituting the battery system 100. The vehicle side control part 96 and the control circuit of the battery system 100 can perform communication therebetween, and when the ignition key is operated to be ON, the vehicle side control part 96 detects this operation and notifies the control circuit of the battery system 100. Upon receipt of the notification, the control circuit sets the contactor 90 ON. Thus, the electric power starts being supplied from the battery system 100 to the electric power converting part 91, thereby enabling the vehicle to run. On the other hand, when the ignition key is operated to be OFF, the vehicle side control part 96 detects this operation and notifies the control circuit of the battery system 100. Upon receipt of the notification, the control circuit sets the contactor 90 to OFF. Thus, the electric power stops being supplied from the battery system 100 to the electric power converting part 91. For the particular configuration of the battery system 100, it is possible to adopt, for example, the configuration of the battery system of the fifth embodiment shown in FIG. 15. Also, it is possible to adopt the structure of the battery system of the other embodiments than the fifth. Further, the contactor 90 may be replaced with a relay.

During acceleration or hill-climbing, the vehicle side control part 96 performs discharge control in which the electric power is supplied from the assembled battery of the battery system 100 to the motor 92 to drive the motor 92 as described above. And during decelerating or running on a downward slope, it performs charge control in which the assembled battery of the battery system 100 is charged with the electric power generated in the motor 92.

In the electric vehicle according to the present invention, when the control circuit of the battery system 100 detects a disconnection on any wire harness between the assembled battery and the voltage input terminals of the voltage detecting device in the state where the contactor 90 is set ON, the control circuit of the battery system 100 switches the contactor 90 OFF and notifies the vehicle side control part 96 of the occurrence of a disconnection. The vehicle side control part 96, upon receipt of the notification, performs a predetermined control operation. Thus, in the case of detection of a disconnection, the contactor 90 is switched OFF, and therefore, the electric power is not supplied from the assembled battery of the battery system 100 to the motor 92, nor is the electric power generated in the motor 92 supplied to the assembled battery of the battery system 100. And thus, it is possible to prevent the cells forming the assembled battery from being overcharged or overdischarged.

Here, it is also possible to adopt the structure described below instead of the structure in which the contactor 90 is switched OFF in the case of detection of a disconnection. For example, since it is dangerous that the cell is overcharged, the vehicle side control part 96 prohibits charging and permits only discharging upon receipt of the notice of disconnection from the control circuit of the battery system 100. Also, the vehicle side control part 96 permits only discharging and restrict the output of the assembled battery of the battery system 100 by restricting the output of the motor 92 (motor torque × number of rotation),

In the battery systems of the embodiments described above, as shown in FIGS. 1, 5, 6, 11, 15 and 18, the clamp diodes D1 to D10 are provided between two adjacent voltage detecting lines. However, it is also possible to omit the clamp diodes D1 to D10. In the battery system without the clamp diodes D1 to D10, in the case of occurrence of a disconnection on one wire harness, the potential of the voltage detecting line connected to the wire harness falls below that of the adjacent voltage detecting line on the negative electrode side, to become nearly zero. Therefore, when the potential of the voltage detecting line falls to a predetermined threshold value or when the potential of the voltage detecting line on the positive electrode side falls below that of the voltage detecting line on the negative electrode side, it is possible to determine the occurrence of a disconnection. Here, the threshold value is set for each voltage detecting line, and is set to the value equal to or below the integration value of the voltages of all the cells interposed between the voltage detecting line at the end of the assembled battery on the negative electrode side and the voltage detecting line for which the threshold value is to be set at the time the charging capacities of said cells are zero.

Also, in the battery system of the third embodiment, as shown in FIG. 6, the first current line 561 is connected to ground via the disconnection detection ON/OFF switching element SW. However, it is also possible to omit the disconnection detection ON/OFF switching element SW so that the 10 current lines 561 to 570 are connected to ground. Further, it is possible to connect the 10 current lines 561 to 570 to the disconnection detection ON/OFF switching element respectively so that each current line is connected to ground via the disconnection detection ON/OFF switching element.

In the battery system of the third embodiment, the base of one switching element SW2 of the two switching elements SW1, SW2 of the discharging circuit 50 is connected to ground via each of the switching control/disconnection detection resistors R11 to R20. However, it is also possible to provide three or more switching elements so that the bases of two or more of the elements are connected to ground via the switching control/disconnection detection resistors respectively.

In the battery systems of the first and second embodiments, the points 251 to 260 connected to ground via the disconnection detection resistors R1 to R10 are located on the ADC 21 side of the capacitors C1 to C10, and the clamp diodes D1 to D10 are located on the ADC 21 side of the points 251 to 260. However, the capacitors C1 to C10, the points 251 to 260, and the clamp diodes D1 to D10 can take any positional relationship thereof as long as they are located between the input terminals 201 to 211 and the ADC 21.

Also, in the battery system of the third embodiment, the capacitors C1 to C10, the discharging circuits 50, the second switching control/disconnection detection resistors R21 to R30, and the clamp diodes D1 to D10 can take any positional relationship thereof as long as they are located between the input terminals 501 to 511 and the ADC 51.

Further, in the battery systems of the first and second embodiments, the resistance values of the disconnection detection resistors R1 to R10 shown in FIGS. 1 and 5 are set to the same value. However, it is also possible to set the resistance values so that the disconnection detection resistors R1 to R10 have greater resistance values as they are connected to the voltage detecting lines closer to the positive electrode of the assembled battery 1, in order for the consumption currents of the cells forming the assembled battery 1 to be substantially the same. The reason of this resistance value setting is as follows.

Even in the state where no disconnection has occurred on the wire harnesses 401 to 411, a small amount of current flows from the cells B1 to B10 into ground via the disconnection detection resistors R1 to R10. Here, the current flows from the cell B1 only into the disconnection detection resistor R1, from the cell B2 into the disconnection detection resistors R1 and R2, from the cell B3 into the disconnection detection resistors R1, R2 and R3, ...and from the cell B10 into the disconnection detection resistors R1 to R10. Therefore, the consumption currents of the cells vary, and thereby the voltages across the cells vary. In view of this, the resistance values are set so that the disconnection detection resistors R1 to R10 have greater resistance values as they are connected to the voltage detecting lines closer to the positive electrode of the assembled battery 1, in order for the consumption currents of the cells forming the assembled battery 1 to be substantially the same.

In the structure in which a plurality of disconnection detection resistors are interposed on each current line, the resistance values of the disconnection detection resistors are set so that the sum of the resistance values of the plurality of disconnection detection resistors is greater as the resistors are connected to the voltage detecting lines closer to the positive electrode of the assembled battery 1.

Still further, in the battery system of the third embodiment, it is possible to set the resistance values of the first switching control/disconnection detection resistors and the second switching control/disconnection detection resistors so that the sum of the respective resistance values of the first switching control/disconnection detection resistors R11 to R20 and the second switching control/disconnection detection resistors R21 to R30 shown in FIG. 6 is greater as they are connected to the voltage detecting lines closer to the positive electrode of the assembled battery 1.

In addition, in the structure in which each of the first switching control/disconnection detection resistors R11 to R20 and the second switching control/disconnection detection resistors R21 to R30 are replaced with a first switching control/disconnection detection circuit comprising a plurality of resistors connected to each other in series and a second switching control/disconnection detection circuit comprising a plurality of resistors connected to each other in series, the resistance values of the resistors forming the first and second switching control/disconnection detection circuits are set so that the sum of the resistance values of the first switching control/disconnection detection circuit and the second switching control/disconnection detection circuit is greater as they are connected to the voltage detecting line closer to the positive electrode of the assembled battery 1.

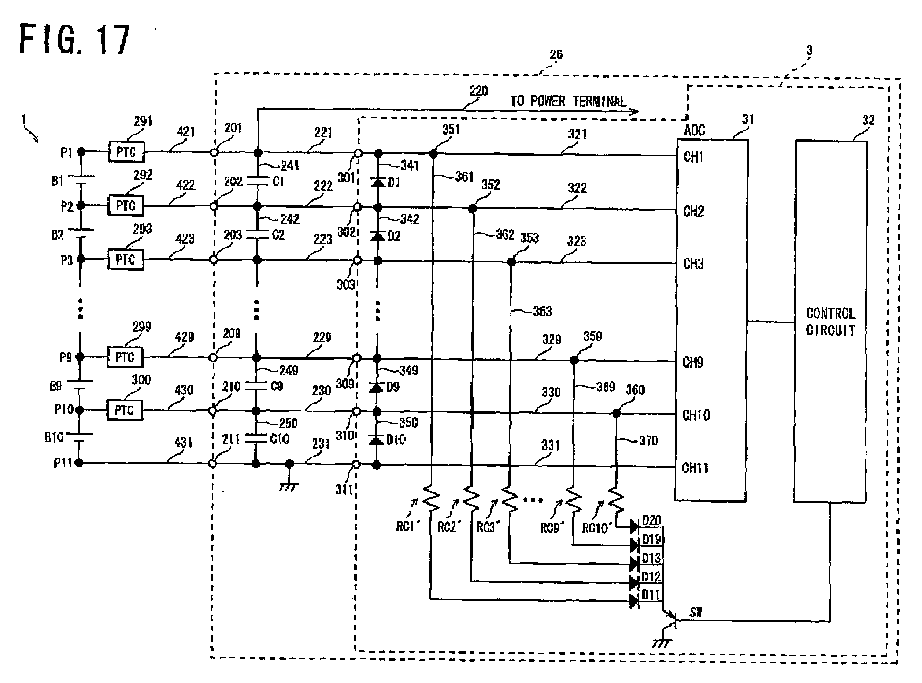

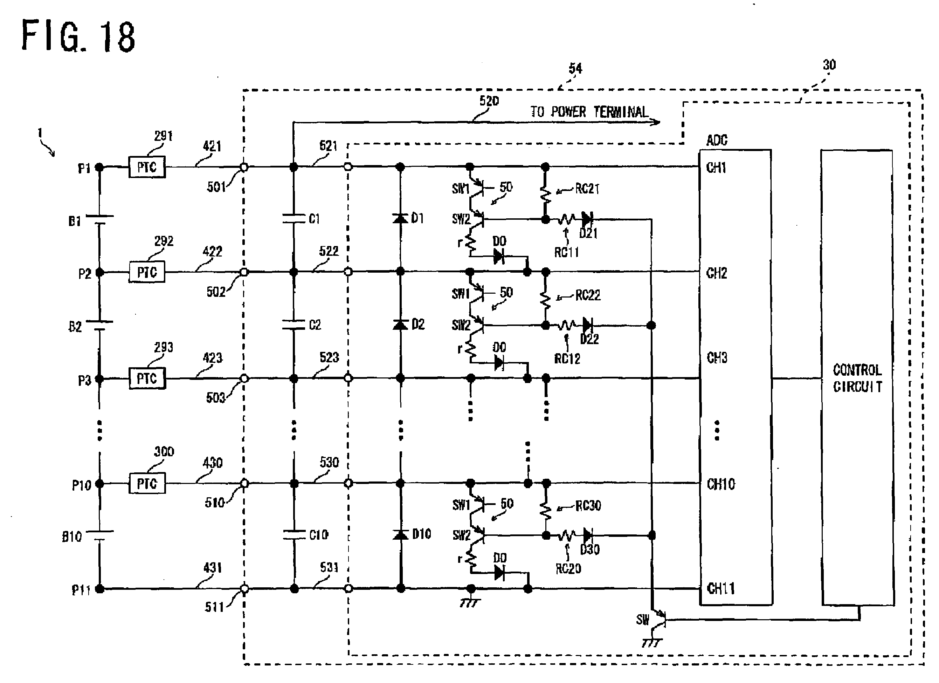

Furthermore, although both ends of the assembled battery 1 P1, P11 and the connecting points P2 to P10 between the cells are connected to 11 voltage input terminals of the voltage detecting device respectively via wire harnesses 401 to 411 in the battery systems of the first to fifth embodiments, it is also possible to connect them via a conducting wire printed on a flexible printed board. In such a configuration, as shown in FIGS. 17 and 18, it is also possible to respectively provide the PTC elements 291 to 300 on conducting wires 421 to 430 printed on a flexible printed board, thereby realizing a similar effect to that obtained in the configuration of providing the PTC elements 291 to 300 on the voltage detecting lines 221 to 230 and 521 to 530 of the voltage detecting devices 25, 53 as shown in FIG. 15 or 16.

## Claims

1. A voltage detecting device detecting voltage across each of a plurality of cells connected to each other in series to form an assembled battery, the device comprising a plurality of voltage input terminals to be connected to a plurality of voltage detecting points of the assembled battery via wires respectively, a plurality of voltage detecting lines respectively extending from the plurality of voltage input terminals, a plurality of first coupling lines each coupling two adjacent voltage detecting lines to each other, a plurality of capacitative elements respectively interposed on the plurality of first coupling lines, and voltage detecting means for detecting voltage across each cell based on voltage inputted from each voltage detecting line, the voltage detecting device being **characterized in that**: at least all the voltage detecting lines respectively disposed on the positive electrode side of the cells are each connected to ground via one or more disconnection detection resistors, and the voltage detecting means comprises disconnection detecting means for detecting a disconnection of any of the wires between the plurality of voltage detecting points of the assembled battery and the plurality of voltage input terminals based on voltage inputted from each voltage detecting line.

2. The voltage detecting device according to claim 1, wherein the disconnection detecting means determines that a disconnection has occurred when a potential of any of the voltage detecting lines falls to or below a predetermined threshold value.

3. The voltage detecting device according to claim 1, wherein the voltage detecting device comprises a plurality of second coupling lines provided in parallel with the plurality of first coupling lines and each coupling two adjacent voltage detecting lines to each other, and rectifying devices are respectively interposed on the plurality of second coupling lines with a forward direction of the rectifying devices facing the positive electrode side of the assembled battery.

4. The voltage detecting device according to claim 3, wherein the disconnection detecting means determines that a disconnection has occurred when a potential difference of two adjacent voltage detecting lines falls to or below a predetermined threshold value.

5. The voltage detecting device according to any one of claims 1 to 4, wherein current lines respectively extend from the at least all the voltage detecting lines respectively disposed on the positive electrode side of the cells, one of the plurality of current lines is connected to ground via a disconnection detection ON/OFF switching element while the other current lines are connected to said one current line, the one or more disconnection detection resistors are interposed on each current line, and a rectifying device is interposed on each current line with a forward direction of the rectifying device facing the ground side.

6. A voltage detecting device detecting voltage across each of a plurality of cells connected to each other in series to form an assembled battery, the device comprising a plurality of voltage input terminals to be connected to a plurality of voltage detecting points of the assembled battery via wires respectively, a plurality of voltage detecting lines respectively extending from the plurality of voltage input terminals, a plurality of first coupling lines each coupling two adjacent voltage detecting lines to each other, a plurality of capacitative elements respectively interposed on the plurality of first coupling lines, and voltage detecting means for detecting voltage across each cell based on voltage inputted from each voltage detecting line, the voltage detecting device being **characterized in that**: the voltage detecting device comprises a plurality of second coupling lines provided in parallel with the plurality of first coupling lines and each coupling two adjacent voltage detecting lines to each other, discharging circuits each comprising at least two switching elements and one or more resistors connected to each other in series are respectively interposed on the plurality of second coupling lines, a base or gate of at least one switching element of the at least two switching elements of each discharging circuit is connected to ground via a first resistance circuit comprising one or more resistors, second resistance circuits each comprising one or more resistors are respectively interposed on third coupling lines each coupling an end of the first resistance circuit on the discharging circuit side and the voltage detecting line located on the positive electrode side of each of the discharging circuits to each other, and the voltage detecting means comprises disconnection detecting means for detecting a disconnection of any of the wires between the plurality of voltage detecting points of the assembled battery and the plurality of voltage input terminals based on voltage inputted from each voltage detecting line.

7. The voltage detecting device according to claim 6, wherein the disconnection detecting means determines that a disconnection has occurred when a potential of any of the voltage detecting lines falls to or below a predetermined threshold value.

8. The voltage detecting device according to claim 6,
wherein the voltage detecting device further comprises a plurality of fourth coupling lines provided in parallel with the plurality of first coupling lines and each coupling two adjacent voltage detecting lines to each other, and rectifying devices are respectively interposed on the plurality of fourth coupling lines with a forward direction of the rectifying device facing the positive electrode side of the assembled battery.

9. The voltage detecting device according to claim 8, wherein the disconnection detecting means determines that a disconnection has occurred when a potential difference of two adjacent voltage detecting lines falls to or below a predetermined threshold value.

10. The voltage detecting device according to any one of claims 6 to 9, wherein current lines respectively extend from the bases or gates of the switching element of the discharging circuits, one of the plurality of current lines is connected to ground via a disconnection detection ON/OFF switching element while the other current lines are connected to said one current line, the first resistance circuit is interposed on each current line, and a rectifying device is interposed on each current line with a forward direction of the rectifying device facing the ground side.

11. An assembled battery system comprising an assembled battery comprising a plurality of cells connected to each other in series and the voltage detecting device according to any one of claims 1 to 10.

12. An electric vehicle operating using an assembled battery comprising a plurality of cells connected to each other in series as an electric power source, wherein the voltage detecting device according to any one of claims 1 to 10 is connected to the assembled battery.

13. A voltage detecting circuit detecting voltage across each of a plurality of cells connected to each other in series to form an assembled battery, the circuit comprising a plurality of voltage input terminals into which potentials of a plurality of voltage detecting points of the assembled battery are respectively inputted, a plurality of voltage detecting lines respectively extending from the plurality of voltage input terminals, and voltage detecting means for detecting voltage across each cell based on voltage inputted from each voltage detecting line, the voltage detecting circuit being **characterized in that**: at least all the voltage detecting lines respectively disposed on the positive electrode side of the cells are each connected to ground via one or more disconnection detection resistors.

14. A voltage detecting circuit detecting voltage across each of a plurality of cells connected to each other in series to form an assembled battery, the circuit comprising a plurality of voltage input terminals into which potentials of a plurality of voltage detecting points of the assembled battery are respectively inputted, a plurality of voltage detecting lines respectively extending from the plurality of voltage input terminals, and voltage detecting means for detecting the voltage across each cell based on voltage inputted from each voltage detecting line, the voltage detecting circuit being **characterized in that:** the voltage detecting circuit comprises a plurality of first coupling lines each coupling two adjacent voltage detecting lines to each other, discharging circuits each comprising at least two switching elements and one or more resistors connected to each other in series are respectively interposed on the plurality of first coupling lines, a base or gate of at least one switching element of the at least two switching elements of each discharging circuit is connected to ground via a first resistance circuit comprising one or more resistors, and second resistance circuits each comprising one or more resistors are respectively interposed on second coupling lines each coupling an end of the first resistance circuit on the discharging circuit side and the voltage detecting line located on the positive electrode side of each of the discharging circuits to each other.
